# EUROPEAN PATENT SPECIFICATION

(11) **EP 3 795 608 B1**
(45) Date of publication and mention of the grant of the patent: **28.12.2022**
(21) Application number: 19804383.8
(22) Date of filing: 16.05.2019
(51) Int. Cl.: C08G 65/32, B24B 37/24, C08F 290/14, C08G 18/64, C08L 71/00, C09K 9/02, H01L 21/304, C08B 37/16, C08L 5/16, G02B 1/00

(54) **LOW MOISTURE CONTENT POLYROTAXANE MONOMER AND CURABLE COMPOSITION COMPRISING SAID MONOMER**
POLYROTAXANMONOMER MIT NIEDRIGEM FEUCHTIGKEITSGEHALT UND HÄRTBARE ZUSAMMENSETZUNG MIT DIESEM MONOMER
MONOMÈRE DE POLYROTAXANE À FAIBLE TENEUR EN HUMIDITÉ ET COMPOSITION DURCISSABLE COMPRENANT LEDIT MONOMÈRE

(30) Priority: 17.05.2018 JP 2018095771
(43) Date of publication of application: 24.03.2021
(73) Proprietor: Tokuyama Corporation, Shunan-shi, Yamaguchi 745-8648 (JP)
(72) Inventor: SHIMIZU, Yasutomo, Shunan-shi, Yamaguchi 745-8648 (JP); KAWASAKI, Takayoshi, Shunan-shi, Yamaguchi 745-8648 (JP); TOCHI, Mitsuki, Urayasu-shi, Chiba 279-0026 (JP)
(74) Representative: Beckmann, Claus
(86) International application number: PCT/JP2019/019585
(87) International publication number: WO 2019/221249

(56) References cited:
- EP-A1- 2 687 544
- EP-A1- 2 687 546
- WO-A1-2006/126511
- WO-A1-2009/128270
- WO-A1-2015/068798
- WO-A1-2015/159875
- JP-A- 2002 198 335
- JP-A- 2006 511 651
- JP-A- 2006 525 378
- JP-A- 2010 202 762
- JP-A- 2017 048 305
- JP-A- 2018 058 988

## Description

### Technical Field

The present invention relates to a novel polyrotaxane monomer, a novel curable composition containing the monomer, and a novel cured article formed of the curable composition.

### Background Art

Polyrotaxane has cyclic molecules and has a specific composite molecular structure composed of a linear molecule (axial molecule) that skewer-like threads through the cyclic molecules and a bulky group (end group) formed at both ends of the axial molecule to prevent the cyclic molecules from separating (dethreading) from the axial molecule. In the polyrotaxane, the cyclic molecules can move relatively on the axial molecule, and therefore the polyrotaxane has various characteristics, especially excellent mechanical characteristics, and is expected to be developed for various applications. For imparting these characteristics to various materials, a lot of attempts are being made to further introduce a polymerizable functional group into the polyrotaxane structure and to introduce the resultant polyrotaxane structure into various polymer materials.

Specific developed examples include optical materials such as contact lenses as shown in PTL 1, and rollers, belts, sealings, electronic materials and optical products attained by developing to thermosetting polyurethanes as in PTLs 2 to 4.

As optical materials, the polyrotaxane monomer is used in the following applications. Specifically, one use is a field of photochromic spectacle lenses. Photochromic spectacle lenses are rapidly colored outdoors under irradiation with light including UV rays such as sunlight to thereby function as sunglasses, while indoors with no such photoirradiation, they decolor to function as transparent ordinary eyeglasses, and a demand for such lenses is increasing these days. Recently, a photochromic composition containing a polyrotaxane monomer for use for photochromic eyeglasses has been disclosed (see PTLs 5 to 8). In PTLs 5 to 8, a photochromic composition contains a polyrotaxane monomer and therefore achieves both improved mechanical strength owing to crosslinking of the polyrotaxane monomer therein and excellent photochromic performance (coloration density and decoloring speed) owing to the existence of a free space around the polyrotaxane (monomer). PTLs 5 to 8 disclose some methods for molding such optical materials.

Application of a polyrotaxane monomer to a polishing pad material of a polishing member is under investigation. Specifically, a polyrotaxane monomer is used as a pad material in a CMP (chemical mechanical polishing) method (hereinafter this may be referred to as a polishing pad). A CMP method is a polishing method of providing excellent surface planarity, and is employed especially in a production process for liquid-crystal displays (LCD), hard disc glass substrates, silicon wafers and semiconductor devices.

As the CMP method, a polishing system of applying a slurry (polishing liquid) of a dispersion of abrasive grains in an alkali solution or an acid solution during a process of polishing is generally employed. Specifically, the subject to be polished is planarized by the mechanical action of the abrasive grains in the slurry and by the chemical action of the alkali solution or the acid solution. In general, while the slurry is applied to the surface of a subject to be polished, and a polishing pad material is kept in contact with the surface and kept slid thereon to planarize the surface of the subject.

As a material for such a polishing pad, a polishing material formed of an urethane curable composition is known (see PTL 9). Further, as one capable of more improving wear resistance, a polishing material using p-phenylene diisocyanate as a polyisocyanate compound is known (see PTL 10). By introducing a polyrotaxane monomer into such a polishing pad material, it is expected to produce a higher performance pad. Actually, in PTLs 2 to 4, the urethane resin using a polyrotaxane monomer expresses excellent mechanical characteristics, and is said to be usable as a polishing pad.

PTL 11 discloses a powdered hydrophilic modified polyrotaxane, which enables production of a powdered hydrophilic modified polyrotaxane excellent in storage stability, wherein the polyrotaxane has a drying loss between 0.8 wt.% and 2 wt.%.

PTL 12 discloses a hydrophilic modified polyrotaxane having a drying loss over 1 wt.%.

### Citation List

### Patent Literature

PTL 1: WO2005/095493
PTL 2: WO2015/159875
PTL 3: JP 2017-48305 A
PTL 4: JP 2017-75301A
PTL 5: WO2015/068798
PTL 6: WO2017/038957
PTL 7: WO2016/143910
PTL 8: WO2018/030257
PTL 9: JP 2007-77207 A
PTL 10: JP 2015-178558A
PTL 11: EP 2 687 546 A1
PTL 12: EP 2 687 544 A1

### Summary of Invention

### Technical Problem

As described above, a polyrotaxane monomer can impart excellent functions to a polymerized cured product (polymer) using it, and various investigations thereof are being made in many aspects. However, as a result of investigations, the present inventors have found that, in the related techniques, there still remains room for improvement in the following points.

For example, in the case where a polyrotaxane monomer is introduced into the urethane resin described in Examples in PTLs 2 to 4, there is room for development in the following points. Specifically, in the case where a polyrotaxane monomer is applied to a polishing pad material using the urethane resin, a foamed urethane is generally used, but in the case, the size of the foams of the polishing pad resin using the polyrotaxane monomer tends to be nonuniform, and there occurs a problem of foaming unevenness owing to mixing with large foams or to uneven thickness. The problem of unevenness in size of foams is considered to occur also in other uses of using urethane foams.

Further, in the case where the already-existing polyrotaxane monomer is used as an optical material, it has been found that there is room for improvement in the following points. PTLs 5 to 8 say that the moldability is on a level almost free from problems, but as a result of more accurate evaluations that the inventors have made, it has been found that there still remains room for improvement in the following points. For example, regarding urethane-based lenses, foams may be mixed in some type of lenses, and the moldability is often insufficient. Also regarding lenses formed of a (meth)acrylate-based polymer composition containing a polyrotaxane monomer, the physical properties of the lenses sometimes differ and fluctuate.

The above-mentioned phenomena tend to occur in a curable composition containing a relatively large amount of a polyrotaxane monomer or in a curable composition stored for a long period of time in point of the quality and the physical properties of the resultant urethane foams or the cured product such as lenses, that is, the quality and the physical properties thereof tend to fluctuate.

Consequently, an object of the present invention is to provide a polyrotaxane monomer that can produce a high-quality material at high productivity and at high production yield while the excellent mechanical characteristics of the polyrotaxane monomer are maintained as such.

### Solution to Problem

The present inventors have repeated assiduous studies for the purpose of solving the above-mentioned problems. With that, the inventors have investigated details of a polyrotaxane monomer-containing curable composition. In general, a polyrotaxane monomer could not be a main ingredient in a curable composition in some cases. For the above-mentioned uses, for example, for uses for urethane foams and lenses, the blending amount of a polyrotaxane monomer is 50% by mass or less. Consequently, heretofore, impurities in a polyrotaxane monomer are not taken into consideration so much. The present inventors have paid attention to this point, and investigated impurities contained in the polyrotaxane monomer. As a result, the inventors have found that the water content contained in the polyrotaxane monomer has an influence on fluctuation of the physical properties of the resultant cured product. With that, the inventors have further found that a polyrotaxane monomer in which the water content is not more than a predetermined level can solve the above-mentioned problems, and have completed the present invention.

Specifically, a first aspect of the present invention is the polyrotaxane monomer defined in claim 1. The polyrotaxane monomer of the present invention is referred to as polyrotaxane monomer (A).

A second aspect of the present invention is a curable composition containing:
the polyrotaxane monomer (A), and
any other polymerizable monomer (B) than the polyrotaxane monomer (A).

A third aspect of the present invention is a photochromic curable composition containing the second aspect of the present invention, and
a photochromic compound (D).

A fourth aspect of the present invention is a polishing pad produced by curing the second aspect of the present invention.

A fifth aspect of the present invention is a photochromic cured product produced by curing the third aspect of the present invention.

### Advantageous Effects of Invention

In the case where the polyrotaxane monomer of the present invention is used as a curable composition prepared by mixing the monomer with any other polymerizable monomer, it exhibits an especially excellent effect. Specifically, the polyrotaxane monomer of the present invention can prevent the physical properties of a cured product of the curable composition, for example, an urethane foam to be a polishing pad or a lens (especially a photochromic compound-containing lens) from varying or fluctuating. As a result, the production yield of products (urethane foams, lenses) of the cured product can be improved.

The photochromic cured product formed of the polyrotaxane monomer-containing curable composition realizes increased productivity while expressing excellent photochromic characteristics. The polishing pad formed of the polyrotaxane monomer-containing curable composition realizes increased productivity with little fluctuation while expressing excellent polishing characteristics and wear resistance. Further, the storable stability of the curable composition can be increased.

### Brief Description of Drawing

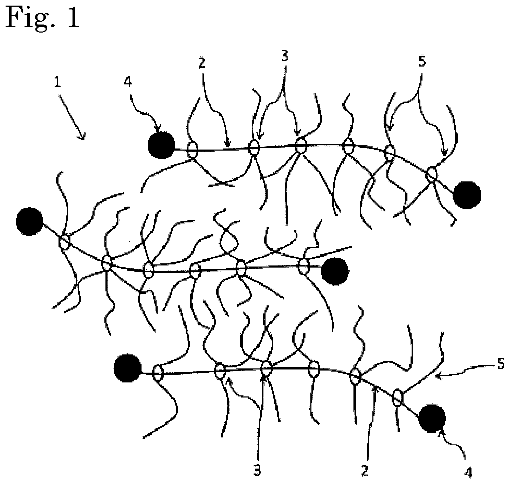

Fig. 1 is a schematic view showing a molecular structure of a polyrotaxane for use in the present invention.

### Description of Embodiments

The polyrotaxane monomer (A) of the present invention is a polyrotaxane monomer having a composite molecular structure composed of cyclic molecules and an axial molecule that threads through the rings of the cyclic molecules and has a bulky group at both ends thereof so as not to dethread the rings, and having a polymerizable functional group in the molecule, and contains an impurity of water in an amount of 5000 ppm or less as further defined in claim 1. In other words, the present invention is a polyrotaxane monomer composition containing the above polymerizable group-having polyrotaxane monomer and water in an amount of 5000 ppm or less.

The polyrotaxane monomer (A) of the present invention (hereinafter may be simply referred to as component (A)) is described below.

### Polyrotaxane Monomer (A)

A polyrotaxane monomer is a known compound. As in Fig. 1, a polyrotaxane monomer is shown as "1" as a whole, and has a composite molecular structure formed of a linear axial molecule (2) and cyclic molecules "3". Specifically, the cyclic molecules "3" clathrate the linear axial molecule "2", and the axial molecule "2" threads through the rings that the cyclic molecules "3" have. Accordingly, the cyclic molecules "3" can slide freely on the axial molecule "2", but a bulky end group "4" is formed at both ends of the axial molecule "2" to prevent the cyclic molecules "3" from dethreading from the axial molecule "2".

In the polyrotaxane monomer, the cyclic molecules "3" can slide on the axial molecule "2". Accordingly, when used in a photochromic cured product, the polyrotaxane monomer can readily form a free space around the photochromic compound therein. Further, it is considered that the slidable effect can express excellent mechanical characteristics to improve the wear resistance of the cured product and to express a low hysteresis loss. Consequently, when used in a polishing pad agent, the polyrotaxane monomer can express excellent polishing characteristics and wear resistance. Though not clear, it is considered that, since the polyrotaxane monomer has such specific motility characteristics, the water content therein will have to be in a specific ratio.

In the polyrotaxane monomer (A) for use in the present invention, various molecules are known as the axial molecule, and for example, the linear structural part of the axial molecule may be a straight chain or a branched chain so far as it can thread through the rings that the cyclic molecules have, and the part may be generally formed of a polymer.

### <Axial Molecule; Polyrotaxane Monomer (A)>

The polymer to form such an axial molecule includes polyvinyl alcohol, polyvinyl pyrrolidone, cellulose-based resins (such as carboxymethyl cellulose, hydroxyethyl cellulose and hydroxypropyl cellulose), polyacrylamide, polyethylene oxide, polyethylene glycol, polypropylene glycol, polyvinyl acetal, polyvinyl methyl ether, polyamine, polyethylene imine, casein, gelatin, starch, olefin-based resins (such as polyethylene and polypropylene), polyester, polyvinyl chloride, styrene-based resins (such as polystyrene and acrylonitrile-styrene copolymer resin), acrylic resins (such as poly(meth)acrylic acid, polymethyl methacrylate, polymethyl acrylate and acrylonitrile-methyl acrylate copolymer resin), polycarbonate, polyurethane, vinyl chloride-vinyl acetate copolymer resin, polyvinyl butyral, polyisobutylene, polytetrahydrofuran, polyaniline, acrylonitrile-butadiene-styrene copolymer (ABS resin), polyamides (such as nylon), polyimide, polydienes (such as polyisoprene and polybutadiene), polysiloxanes (such as polydimethylsiloxane), polysulfone, polyimine, polyacetic anhydride, polyurea, polysulfide, polyphosphazene, polyketone polyphenylene and polyhalo olefins. These polymers may be appropriately copolymerized or modified.

A preferable polymer to form the axial molecule in the polyrotaxane monomer (A) for use in the present invention is polyethylene glycol, polyisoprene, polyisobutylene, polybutadiene, polypropylene glycol, polytetrahydrofuran, polydimethylsiloxane, polyethylene, polypropylene, polyvinyl alcohol, or polyvinyl methyl ether, and polyethylene glycol is the most preferable.

When the molecular weight of the above axial molecule is too high, and when the polyrotaxane monomer is mixed with any other components such as any other polymerizable monomer, the viscosity of the resultant mixture may increase and not only it becomes difficult to handle the mixture but also the compatibility of the components tends to lower. From this viewpoint, the weight average molecular weight Mw of the axial molecule is preferably falls within a range of 1,000 to 100,000, especially 1,500 to 50,000, especially preferably 2,000 to 30,000. The weight average molecular weight Mw is a value measured according to the measurement method of GPC described in the section of Examples given below.

### <Bulky Group; Polyrotaxane Monomer (A)>

The axial molecule threads through the rings of the cyclic molecules, and has a bulky group at both ends so as not to dethread the rings. The bulky group to be formed at both ends (both terminals) of the axial molecule is not specifically limited so far as it is a group to prevent the cyclic molecules from dethreading from the axial molecule. From the viewpoint of bulkiness, the group includes an adamantyl group, a trityl group, a fluoresceinyl group, a dinitrophenyl group, and a pyrenyl group, and especially from the viewpoint of easiness in introduction, the group may be an adamantyl group.

### <Cyclic Molecule; Polyrotaxane Monomer (A)>

The cyclic molecule may be any one that has a ring of a size capable of clathrating the above-mentioned axial molecule, and such a ring includes a cyclodextrin ring, a crown ether ring, a benzo-crown ring, a dibenzo-crown ring, and a dicyclohexano-crown ring, and a cyclodextrin ring is especially preferred.

Cyclodextrin rings are available in an α-form (ring inner diameter: 0.45 to 0.6 nm), a β-form (ring inner diameter: 0.6 to 0.8 nm) or a γ-form (ring inner diameter: 0.8 to 0.95 nm). A mixture of these can be used. In the present invention, an α-cyclodextrin ring and a β-cyclodextrin ring are preferred, and an α-cyclodextrin ring is most preferred.

In the cyclic molecule having the aforementioned ring, one or more cyclic molecules clathrate one axial molecule. In general, at least one or more cyclic molecules clathrate one axial molecule, and when the maximum clathrating number of the cyclic molecules capable of clathrating one axial molecule is defined as 1, the clathrating number of the cyclic molecules is at most 0.6 or less, and is more preferably within a range of 0.003 to 0.5.

When the clathrating number of the cyclic molecules is too large, the cyclic molecules exist densely relative to one axial molecule to lower the mobility of the structure and, as a result, not only the mechanical characteristics thereof may lower but also the handleability of the polymerizable composition to be prepared by mixing with any other polymerizable monomer (B) than the polyrotaxane monomer may also lower owing to the increase in the molecular weight of the structure, and eventually the cured product may tend to express molding failure.

The maximum clathrating number of cyclic molecules relative to one axial molecule can be calculated from the length of the axial molecule and the thickness of the ring of the cyclic molecule. For example, in one example where the linear moiety of the axial molecule is formed of polyethylene glycol and the cyclic molecule is an α-cyclodextrin ring, the maximum clathrating number is calculated as follows. Specifically, two of the repeating unit [-CH₂-CH₂O-] of polyethylene glycol approximate the thickness of one α-cyclodextrin ring. Thus, the number of the repeating unit is calculated from the molecular weight of the polyethylene glycol, and 1/2 of the thus-calculated repeating unit number is the maximum clathrating number of cyclic molecules. With reference to the maximum clathrating number of 1.0, the clathrating number of cyclic molecules is controlled to fall within the above-mentioned range.

### <Side Chain of cyclic molecule; Polyrotaxane Monomer (A)>

In the polyrotaxane monomer (A) for use in the present invention, a side chain is introduced into at least a part of the cyclic molecules and a polymerizable functional group is introduced into the side chain; in particular, the ring that the above-mentioned cyclic molecule has may have a side chain introduced at least partly thereinto. The side chain is expressed as "5" in Fig. 1.

Though not specifically limited, the side chain is preferably formed of repetition of an organic chain that has a carbon number falling within a range of 3 to 20. The side chain of the type has a number-average molecular weight of, for example, 10000 or less, preferably 5000 or less. In more detail, the number-average molecular weight of the side chain falls within a range of 50 to 10000, preferably 100 to 8000, more preferably 200 to 5000, most preferably 300 to 1500. The number-average molecular weight of the side chain can be controlled depending on the amount of the component to be used in introducing the side chain, and can be determined by calculation, and can also be determined through ¹H-NMR measurement.

Specifically, when the side chain is too short, a space could hardly be formed around the polyrotaxane monomer, and for example, the photochromic reversible reaction of the cured product to be obtained from a photochromic curable composition may tend to be thereby degraded. When the cured product is used as a polishing pad, the planarizing accuracy may tend to lower. Further, When the side chain is too short, the miscibility of the polyrotaxane monomer with any other polymerizable monomer tends to lower. On the contrary, when the side chain is too long, the hardness of the cured product may lower and the wear resistance thereof may tend to lower.

Using the reactive functional group that the cyclic molecule has, the above-mentioned side chain is introduced by modifying the reactive functional group (namely, the side chain is introduced though reaction with the reactive functional group).

Examples of the reactive functional group include a hydroxy group and an amino group, and above all, a hydroxy group is preferred. For example, an α-cyclodextrin ring has 18 OH groups (hydroxy groups) as reactive functional groups, and via the OH group (through reaction with the OH group), a side chain is introduced. Namely, at most 18 side chains can be introduced into one α-cyclodextrin ring. In the present invention, for sufficiently exhibiting the above-mentioned functions of side chains, preferably, 6% to 60% of all the reactive functional groups that all cyclic molecules have are modified with side chains (preferably, side chains are introduced into 6% to 60% of all the reactive functional groups that all cyclic molecules have). The proportion (%) of the functional groups modified with side chains in all the reactive functional groups that rings have may be referred to as a modification degree.

As will be described in detail hereinunder, the reactivity of the reactive functional group of a cyclic molecule is lower than the reactivity of the OH group that the side chain has, and therefore, even though the modification degree is low, there may hardly occur problems of miscibility reduction and bleeding out. Consequently, when the modification degree falls within the above range, a more excellent effect can be exhibited. For reference, in the case where a side chain bonds to 9 of 18 OH groups of the above-mentioned α-cyclodextrin ring, the modification degree (introduction degree) in the case is 50%.

In the present invention, the above-mentioned side chain (organic chain) may be linear or branched so far as its size falls within the above-mentioned range. For side chain introduction, the methods and the compounds disclosed in WO2015/159875 can be appropriately referred to, and ring-opening polymerization; radical polymerization; cationic polymerization; anionic polymerization; and living radical polymerization such as atom transfer radical polymerization, RAFT polymerization and NMP polymerization can be used. According to the above-mentioned method, an appropriately selected compound can be reacted with the functional group that the ring has to thereby introduce a side chain having an appropriate size into the ring.

For example, according to ring-opening polymerization, a side chain derived from a cyclic compound such as a lactone compound or a cyclic ether can be introduced. In the side chain introduced through ring-opening polymerization with a cyclic compound such as a lactone compound or a cyclic ether, an OH group is introduced as a group having an active hydrogen at the end of the side chain.

Among the cyclic compounds, from the viewpoint of easy availability, high reactivity and easiness in size (molecular weight) controlling, cyclic ethers and lactone compounds are preferably used. Specific examples of preferred cyclic compounds are as shown below.

### Cyclic Ethers:

Ethylene oxide, 1,2-propylene oxide, epichlorohydrin, epibromohydrin, 1,2-butylene oxide, 2,3-butylene oxide, isobutylene oxide, oxetane, 3-methyloxetane, 3,3-dimethyloxetane, tetrahydrofuran, 2-methyltetrahydrofuran, and 3-methyl tetrahydrofuran.

### Lactone Compounds:

4-Membered ring lactones such as β-propiolactone, β-methylpropiolactone and L-serine-β-lactone.

5-Membered ring lactones such as γ-butyrolactone, γ-hexanolactone, γ-heptanolactone, γ-octanolactone, γ-decanolactone, γ-dodecanolactone, α-hexyl-γ-butyrolactone, α-heptyl-γ-butyrolactone, α-hydroxy-γ-butyrolactone, γ-methyl-γ-decanolactone, α-methylene-γ-butyrolactone, α,α-dimethyl-γ-butyrolactone, D-erythronolactone, α-methyl-γ-butyrolactone, γ-nonanolactone, DL-pantolactone, γ-phenyl-γ-butyrolactone, γ-undecanolactone, γ-valerolactone, 2,2-pentamethylene-1,3-dioxolan-4-one, α-bromo-γ-butyrolactone, γ-crotonolactone, α-methylene-γ-butyrolactone, α-methacryloyloxy-γ-butyrolactone, and β-methacryloyloxy-γ-butyrolactone.

6-Membered lactones such as δ-valerolactone, δ-hexanolactone, δ-octanolactone, δ-nonanolactone, δ-decanolactone, δ-undecanolactone, δ-dodecanolactone, δ-tridecanolactone, δ-tetradecanolactone, DL-mevalonolactone, δ-lactone 4-hydroxy-1-cyclohexanecarboxylate, monomethyl-δ-valerolactone, monoethyl-δ-valerolactone, monohexyl-δ-valerolactone, 1,4-dioxan-2-one, and 1,5-dioxepan-2-one.

7-Membered ring lactones such as nonalkyl-ε-caprolactone, dialkyl-ε-caprolactone, monomethyl-ε-caprolactone, monoethyl-ε-caprolactone, monohexyl-ε-caprolactone, dimethyl-ε-caprolactone, di-n-propyl-ε-caprolactone, di-n-hexyl-ε-caprolactone, trimethyl-ε-caprolactone, triethyl-ε-caprolactone, tri-n-ε-caprolactone, ε-caprolactone, 5-nonyl-oxepan-2-one, 4,4,6-trimethyl-oxepan-2-one, 4,6,6-trimethyl-oxepan-2-one, and 5-hydroxymethyl-oxepan-2-one.

8-Membered ring lactones such as ξ-enantholactone.

Other lactones such as lactone, lactide, dilactide, tetramethylglycoside, 1,5-dioxepan-2-one, and t-butylcaprolactone.

One alone or plural kinds of the above-mentioned cyclic compounds can be used either singly or as combined.

The side chain-introducing compound favorably used in the present invention is a lactone compound, and lactone compounds such as ε-caprolactone, α-acetyl-γ-butyrolactone, α-methyl-γ-butyrolactone, γ-valerolactone and γ-butyrolactone are especially preferred, and ε-caprolactone is most preferred.

In the case where a side chain is introduced by reaction with a cyclic compound through ring-opening polymerization, the reactive functional group (e.g., hydroxy group) bonding to the ring may be poorly reactive and, in particular, direction reaction with a large molecule may be often difficult owing to steric hindrance. In such a case, for example, for reaction with caprolactone, a method may be employed where a low-molecular compound such as propylene oxide is reacted with the reactive functional group to cause hydroxypropylation, thereby introducing a highly-reactive functional group (hydroxy group) and then a side chain is introduced through ring-opening polymerization using the above-mentioned cyclic compound. In this case, the hydroxypropylated moiety can be considered to be a side chain.

In addition, by introducing a side chain derived from a cyclic compound such as a cyclic acetal, a cyclic amine, a cyclic carbonate, a cyclic iminoether or a cyclic thiocarbonates through ring-opening polymerization, an active hydrogen group-having side chain can be introduced. Among these, specific examples of preferred cyclic compounds are described in WO2015/068798.

A method for introducing a side chain into a cyclic molecule according to radical polymerization is as follows. The ring that the cyclic molecule of polyrotaxane monomer has does not have an active site to be a radical initiation point. Consequently, prior to reacting with a radical-polymerizable compound, a compound for forming a radical initiation point needs to be reacted with the reactive functional group (e.g., OH group) that the ring has to thereby form an active site to be a radical initiation point.

The compound for forming a radical initiation point as above is typically an organic halogen compound, and examples thereof include 2-bromoisobutyryl bromide, 2-bromobutyric acid, 2-bromopropionic acid, 2-chloropropionic acid, 2-bromoisobutyric acid, epichlorohydrin, epibromohydrin, and 2-chloroethyl isocyanate. Namely, such an organic halogen compound can bond to the ring of a cyclic molecule through condensation reaction with the reactive functional group that the ring of the cyclic compound has, and therefore introduce a halogen atom-containing group (organic halogen compound residue) into the ring. In the organic halogen compound residue, a radical is generated as a result of transfer of a halogen atom in radical polymerization, and this can be a radical polymerization initiation point to promote radical polymerization.

The active site-having group to be a radical polymerization initiation point as above (organic halogen compound residue) can also be introduced, for example, by reacting the hydroxy group that the ring has with a compound having a functional group such as an amine, a carboxylic acid, an isocyanate, an imidazole or an acid anhydride to thereby introduce any other functional group than the hydroxy group into the ring, followed by further reacting the other functional group with the above-mentioned organic halogen compound.

The radical polymerizable compound to be used for introducing a side chain through radical polymerization is preferably a compound having an ethylenically unsaturated bond-having group, for example, at least one functional group such as a (meth)acrylate group, a vinyl group or a styryl group (hereinafter this may be referred to as an ethylenically unsaturated monomer). As the ethylenically unsaturated monomer, an oligomer or a polymer (hereinafter also referred to as a macromonomer) having a terminal ethylenically unsaturated bond can also be used. Regarding such ethylenically unsaturated monomers for use herein, specific examples of preferred ethylenically unsaturated monomers are described in WO2015/068798.

### <Polymerizable Functional Group (polymerizable functional group of side chain); Polyrotaxane Monomer (A)>

After a side chain has been introduced according to the above-mentioned method, the functional group in the side chain can be modified into any other functional group for use herein. In the present invention, reaction of a functional group in a side chain with any other compound to thereby introduce a structure derived from the compound into the side chain is referred to as "modification". The compound for use for modification may be any compound capable of reacting with the functional group in a side chain. By selecting the compound, various polymerizable functional groups can be introduced into a side chain, or groups in a side chain can be modified into non-polymerizable groups.

Side chain modification is exemplified. After a terminal OH group-having side chain has been introduced through the above-mentioned ring-opening polymerization, a compound having both a functional group capable of reacting with the OH group in the side chain and a radical polymerizable group can be reacted to introduce the radical polymerizable group into the side chain. Naturally, the terminal OH group can be a polymerizable functional group.

Examples of the functional group capable of reacting with the OH group include an isocyanate group (-NCO group), a carboxy group (-COOH) and an acid chloride group (e.g., -COCl group). By reaction with a compound having an isocyanate group, a radical polymerizable group can be introduced via an urethane bond. By reaction with a compound having a carboxy group or a group or an acid chloride, a radical polymerizable group can be introduced via an ester bond.

Regarding specific examples of a compound having a radical polymerizable group, compounds having an isocyanate group and a (meth)acrylate group include 2-isocyanatoethyl methacrylate, 2-isocyanatoethyl acrylate, and 1,1-(bisacryloyloxymethyl)ethyl isocyanate.

A compound having an acid chloride group (-COCl group) and a (meth)acrylate group can be synthesized by reacting a compound having a carboxy group and a (meth)acrylate group with a chlorinating agent such as thionyl chloride. A compound having a carboxy group and a (meth)acrylate group includes 2-methacryloyloxyethyl succinate, and β-carboxyethyl acrylate.

A case where a functional group in a side chain is modified into one not having a polymerizable group such as an active hydrogen group or a radical polymerizable group is exemplified. After a side chain with a terminal OH group has been introduced according to the above-mentioned ring-opening polymerization, preferably, a compound having a functional group capable of reacting with the OH group in the side chain and an alkyl group with 2 to 20 carbon atoms, an alkyleneoxy group with 2 to 30 carbon atoms or an aryl group with 6 to 20 carbon atoms in place of the radical polymerizable group is used. Specific examples of the above-mentioned compounds are shown below.

The compound having an isocyanate group is, from the viewpoint of easy availability of raw materials and high reactivity with OH group, preferably an isocyanate compound having 2 to 20 carbon atoms (excluding the carbon atoms of the isocyanate group), more preferably an isocyanate compound having 3 to 10 carbon atoms. Specifically, preferred examples of the isocyanate compound include n-propyl isocyanate, n-butyl isocyanate, n-pentyl isocyanate, n-hexyl isocyanate, and phenyl isocyanate.

The carboxylic acid chloride is, from the viewpoint of easy availability of raw materials and high reactivity with OH group, preferably a carboxylic acid chloride having 2 to 20 carbon atoms (excluding the carbon atom of the carbonyl group), more preferably a carboxylic acid chloride having 2 to 10 carbon atoms. Specifically, preferred examples of the acid chloride include acetyl chloride, propionyl chloride, butyryl chloride, pivaloyl chloride, hexanoyl chloride, and benzoyl chloride.

In the case where a side chain is introduced into a cyclic molecule using a radical polymerizable compound, and where the radical polymerizable compound has any other functional group, the introduced side chain shall have a group having the functional group as it is. Also in the case where the side chain has a radical polymerizable group alone, after a side chain has been formed with the radical polymerizable compound, a part of the side chain may be modified with a group having any other functional group than the radical polymerizable group whereby the other functional group than the radical polymerizable group can be introduced into the side chain.

As understood from the above description, the side chain to be introduced into the ring of a cyclic compound may have various functional groups.

Further, depending on the type of the functional group that the compound used for side chain introduction has, a part of the side chain may bond to the functional group on a ring of a cyclic molecule that the other axial molecule has, thereby forming a crosslinked structure.

### <Preferred Polymerizable Functional Group, and Number thereof>

The polyrotaxane monomer of the present invention has a polymerizable functional group in the molecule as defined in claim 1. The polymerizable functional group is introduced into the side chain introduced into at least a part of the cyclic molecules; the polymerizable functional group may also be introduced into any part of the polyrotaxane monomer, but is, from the viewpoint of reactivity with the polymerizable monomer (B) to be mentioned hereinunder, preferably introduced into the side chain thereof. Examples of the polymerizable functional group include a hydroxy group, a thiol group, an amino group, an epoxy group, a (meth)acrylate group, and an iso(thio)cyanate group.

Though not specifically limited, the polymerizable functional group is most preferably at least one group selected from a hydroxy group (OH group) and a (meth)acrylate group in the present invention. Specifically, preferred embodiments of the polyrotaxane monomer include a case having an OH group alone, a case having a (meth)acrylate group alone, and a case having both an OH group and a (meth)acrylate group as the polymerizable functional group. Regarding the case having an OH group (hydroxy group), when the end of the side chain introduced in reaction with a reactive functional group of a cyclic molecule is a hydroxy group, the introduced hydroxy group may be a polymerizable functional group as it is. A (meth)acrylate group can be introduced into the end of the side chain according to the above-mentioned method.

In the polyrotaxane monomer (A), the number of the polymerizable functional groups is not specifically limited. In particular, since an excellent effect is achieved by introduction of a polyrotaxane moiety into a resin to be a matrix, the polyrotaxane monomer preferably has at least two polymerizable functional groups in the molecule.

At least a part of the the above-mentioned cyclic molecules have a side chain introduced therein and a polymerizable functional group is introduced using the side chain. In consideration of reactivity, preferably, the end of the side chain is a polymerizable functional group, and two or more such terminal polymerizable functional groups exist in the molecule. Though the upper limit of the number of the polymerizable functional groups is not specifically limited, the molar number of the polymerizable functional group introduced into the end of the side chain is a number of 10 mmol/g relative to the weight-average molecular weight of the polyrotaxane monomer. The weight-average molecular weight is a value measured through gel permeation chromatography (GPC) to be mentioned in detail hereinunder.

### <Water content; Polyrotaxane Monomer (A)>

The water content in the polyrotaxane monomer (A) of the present invention needs to be 5000 ppm or less. When the water content in the polyrotaxane monomer (A) falls within the range, there can be provided a polyrotaxane capable of stably producing high-quality materials at high productivity while maintaining excellent mechanical characteristics. The water content is a value measured according to the method described in the section of Examples given below, and is expressed as ppm by mass.

Though not clear, the reason is presumed to be as follows. As described above, in the polyrotaxane monomer (A), the cyclic molecules having side chains can freely move as sliding within a range of the axial molecule. As a result, a cured product produced by curing a curable composition prepared by mixing with a polymerizable monomer (B) to be mentioned in detail hereinunder can have a part having such a specific mobility behavior, and consequently, in this, it is considered that water does not exist uniformly but may exist locally therein. As a result, it is considered that the physical properties of the resultant cured product may vary and fluctuate.

From the above, the water content contained in the polyrotaxane monomer (A) is preferably smaller, and is preferably 3000 ppm or less, more preferably 1500 ppm or less. The lower limit of the water content is not specifically limited, but is 100 ppm in consideration of the productivity of the polyrotaxane monomer (A).

Specifically, the present invention is a composition containing a polyrotaxane monomer having a polymerizable group in the molecule, and water, and the composition contains water in an amount of 5000 ppm or less.

### <Preferred Polyrotaxane Monomer (A)>

The polyrotaxane monomer (A) favorably used in the present invention is such that:
the axial molecule is a polyethylene glycol having an adamantyl group bonding to both ends,
the cyclic molecules each have an α-cyclodextrin ring, and a side chain (having an OH group at the end) is introduced into the ring by polycaprolactone,
an OH group or a (meth)acrylate group is introduced as a polymerizable functional group at the end, and most preferably the end has an OH group.

Also preferably, the number-average molecular weight of the axial molecule is 2000 to 50000,
a side chain is introduced by polycaprolactone to 6% or more and 60% or less of the hydroxy group of the α-cyclodextrin ring, and the number-average molecular weight of the side chain is 300 to 600. Also preferably, the number of the polymerizable functional group at the end of the side chain is 2 or more and 5 mmol/g or less in the molecule. With that, also preferably, the water content is 100 to 1500 ppm.

### Production Method for Polyrotaxane Monomer (A)

In the present invention, as a production method for the polyrotaxane monomer (A), the following method can be employed. Specifically, after a polyrotaxane monomer has been produced according to a known method, preferably, this is mixed with an aromatic solvent capable of forming an azeotrope with water, then subjected to azeotropic dehydration, and dried to control the water content therein to be 5000 ppm or less. In particular, in the case where the polyrotaxane monomer has many hydroxy groups as polymerizable functional groups, it may readily contain water, and therefore the production method described above is preferably employed for the case.

The usable aromatic solvent includes benzene, toluene and xylene, and in consideration of operability, toluene is preferably used. Regarding the water-containing polyrotaxane monomer and the aromatic solvent, the amount of the aromatic solvent to be used may vary depending on the amount of water in the monomer. In general, preferably, 50 to 1000 parts by mass of an aromatic solvent is mixed with 100 parts by mass of a water-containing polyrotaxane monomer. Under normal pressure or reduced pressure, the aromatic solvent may be evaporated away to reduce the water content in the polyrotaxane monomer.

Next, the other polymerizable monomer (B) than the polyrotaxane monomer (A) is described. (Hereinunder this may simply be referred to as "polymerizable monomer (B)" or "component (B)".)

### Other Polymerizable Monomer (B) than polyrotaxane monomer (A):

The curable composition of the present invention preferably contains the above-mentioned polyrotaxane monomer (A), and any other polymerizable monomer (B) than the polyrotaxane monomer (A).

In the present invention, the polymerizable monomer (B) may have at least one polymerizable compound capable of reacting with the polyrotaxane monomer (A), and any one can be used with no specific limitation. As described above, various polymerizable functional groups can be introduced into the polyrotaxane monomer (A). According to this, the polymerizable monomer (B) can be selected. For example, the polymerizable monomers (B) described in WO2015/068798 are usable.

In the present invention, for example, in the case where the polymerizable functional group that the polyrotaxane monomer (A) has is a polymerizable functional group such as an OH group, an SH group, an amino group and an epoxy group, the polymerizable monomer (B) may be, for example, (B1) an iso(thio)cyanate compound having an iso(thio)cyanate group (hereinafter may be simply referred to as "iso(thio)cyanate compound (B1)" or "component (B1)").

In the case where the polymerizable functional group that the polyrotaxane monomer (A) has is an OH group, an amino group or an NCO group, (B2) an epoxy group-containing monomer having an epoxy group (hereinafter may be simply referred to as "epoxy group-containing monomer (B2)" or "component (B2)") can be selected.

On the other hand, in the case where the polymerizable functional group that the polyrotaxane monomer (A) has is an iso(thio)cyanate group, the polymerizable monomer (B) can be selected from (B3) a (thi)ol compound having at least one group selected from a hydroxy group and a thiol group (hereinafter may be simply referred to as "(thi)ol compound (B3)" or "component (B3)"), and (B4) an amino group-containing monomer having an amino group (hereinafter may be simply referred to as "amino group-containing monomer (B4)" or "component (B4)"). In the present invention, an iso(thio)cyanate group indicates an isocyanate group (NCO group) or an isothiocyanate group (NCS group). Accordingly, in the case where the monomer has plural iso(thio)cyanate groups, the total number of the isocyanate group and the isothiocyanate group may be a plural number.

In the case where the polymerizable functional group that the polyrotaxane monomer (A) has is a radical polymerizable group, the polymerizable monomer (B) is preferably a monomer having a radical polymerizable group, and is especially preferably selected from a (meth)acrylate compound having a (meth)acrylate group.

In the present invention, the water content in the polymerizable monomer (B) is preferably 3000 ppm or less. In the case where plural kinds of polymerizable monomers (B) are used, preferably, the water content is 3000 ppm (ppm by mass) or less relative to the total amount of the polymerizable monomers (B). More preferably, the water content in the polymerizable monomer (B) is 2000 ppm or less, even more preferably 1000 pm or less. Though not specifically limited, the lower limit of the water content in the polymerizable monomer (B) is 10 ppm. The polymerizable monomer (B) is a known monomer, and for reducing the water content therein, any known method may be used.

### (B1) Iso(thio)cyanate Compound

The iso(thio)cyanate compound (B1) is a monomer having at least one isocyanate group or isothiocyanate group. Needless-to-say, for the compound, a monomer having two groups of an isocyanate group and an isothiocyanate group can be selected. Above all, a compound having 2 to 6 iso(thio)cyanate groups in the molecule is preferred, a compound having 2 to 4 such groups is more preferred, and a compound having two such groups is even more preferred.

The iso(thio)cyanate compound (B1) may also be an urethane prepolymer (B12) prepared through reaction of a difunctional polyiso(thio)cyanate compound and a difunctional poly(thi)ol compound described below (hereinafter may be simply referred to as "urethane prepolymer (B12)" or "component (B12)"). The urethane prepolymer (B12) corresponding to the iso(thio)cyanate compound may be one that contains an unreacted iso(thio)cyanate group and is generally used in the art, which can be used in the present invention with no specific limitation.

The iso(thio)cyanate compound (B1) can be roughly grouped into, for example, aliphatic isocyanates, alicyclic isocyanates, aromatic isocyanates, isothiocyanate compounds, and the urethane prepolymer (B12). For the iso(thio)cyanate compound (B1), one kind of the compound alone can be used, or plural kinds thereof can be used. In the case where plural kinds of compounds are used, the mass to be the basis thereof is the total amount of the plural kinds of the compounds. Specific examples of these iso(thio)cyanate compounds include the following monomers.

### Aliphatic Isocyanate; Component (B1)

Difunctional isocyanate monomers such as ethylene diisocyanate, trimethylene diisocyanate, tetramethylene diisocyanate, hexamethylene diisocyanate, octamethylene diisocyanate, nonamethylene diisocyanate, 2,2'-dimethylpentane diisocyanate, 2,2,4-trimethylhexamethylene diisocyanate decamethylene diisocyanate, butene diisocyanate, 1,3-butadiene-1,4-diisocyanate, 2,4,4-trimethylhexamethylene diisocyanate, 1,6,11-trimethylundecamethylene diisocyanate, 1,3,6-trimethylhexamethylene diisocyanate, 1,8-diisocyanate-4-isocyanatemethyloctane, 2,5,7-trimethyl-1,8-diisocyanate-5-isocyanatemethyloctane, bis(isocyanatoethyl) carbonate, bis(isocyanatoethyl) ether, 1,4-butyleneglycol dipropyl ether-ω,ω'-diisocyanate, lysine diisocyanate methyl ester, and 2,4,4-trimethylhexamethylene diisocyanate (corresponding to the difunctional polyiso(thio)cyanate group-containing monomer (B13) to constitute the urethane prepolymer (B12) to be mentioned in detail hereinunder);

Monofunctional isocyanate monomers such as ethyl isocyanate, n-propyl isocyanate, i-propyl isocyanate, butyl isocyanate, and octadecyl isocyanate.

### Alicyclic Isocyanate; Component (B1)

Difunctional isocyanate monomers such as isophorone diisocyanate, (bicyclo[2.2.1]heptane-2,5-diyl)bismethylene diisocyanate, (bicyclo[2.2.1]heptane-2,6-diyl)bismethylene diisocyanate, 2β,5α-bis(isocyanate)norbornane, 2β,5β-bis(isocyanate)norbornane, 2β,6α-bis(isocyanate)norbornane, 2β,6β-bis(isocyanate)norbornane, 2,6-di(isocyanatomethyl)furan, bis(isocyanatomethyl)cyclohexane, dicyclohexylmethane-4,4'-diisocyanate, 4,4-isopropylidenebis(cyclohexyl isocyanate), cyclohexane diisocyanate, methylcyclohexane diisocyanate, dicyclohexyldimethylmethane diisocyanate, 2,2'-dimethyldicyclohexylmethane diisocyanate, bis(4-isocyanate-n-butylidene)pentaerythritol, dimer acid diisocyanate, 2,5-bis(isocyanatomethyl)-bicyclo[2.2.1]-heptane, 2,6-bis(isocyanatomethyl)-bicyclo[2.2.1]-heptane, 3,8-bis(isocyanatomethyl)tricyclodecane, 3,9-bis(isocyanatomethyl)tricyclodecane, 4,8-bis(isocyanatomethyl)tricyclodecane, 4,9-bis(isocyanatomethyl)tricyclodecane, 1,5-diisocyanatodecalin, 2,7-diisocyanatodecalin, 1,4-diisocyanatodecalin, 2,6-diisocyanatodecalin, bicyclo[4.3.0]nonane-3,7-diisocyanate, bicyclo[4.3.0]nonane-4,8-diisocyanate, bicyclo[2.2.1]heptane-2,5-diisocyanate, bicyclo[2.2.1]heptane-2,6-diisocyanate, bicyclo[2.2.2]octane-2,5-diisocyanate, bicyclo[2.2.2]octane-2,6-diisocyanate, tricyclo[5.2.1.0^{2,6}]decane-3,8-diisocyanate, and tricyclo[5.2.1.0^{2,6}]decane-4,9-diisocyanate (corresponding to the difunctional polyiso(thio)cyanate group-containing monomer (B13) to constitute the urethane prepolymer (B12) to be mentioned in detail hereinunder);

Polyfunctional isocyanate monomers such as 2-isocyanatomethyl-3-(3-isocyanatopropyl)-5-isocyanatomethyl-bicyclo[2.2.1]-heptane, 2-isocyanatomethyl-3-(3-isocyanatopropyl)-6-isocyanatomethyl-bicyclo[2.2.1]-heptane, 2-isocyanatomethyl-2-(3-isocyanatopropyl)-5-isocyanatomethyl-bicyclo[2.2.1]-heptane, 2-isocyanatomethyl-2-(3-isocyanatopropyl)-6-isocyanatomethyl-bicyclo[2.2.1]-heptane, 2-isocyanatomethyl-3-(3-isocyanatopropyl)-5-(2-isocyanatoethyl)-bicyclo[2.2.1]-heptane, 2-isocyanatomethyl-3-(3-isocyanatopropyl)-6-(2-isocyanatoethyl)-bicyclo[2.1.1]-heptane, 2-isocyanatomethyl-2-(3-isocyanatopropyl)-5-(2-isocyanatoethyl)-bicyclo[2.2.1]-heptane, 2-isocyanatomethyl-2-(3-isocyanatopropyl)-6-(2-isocyanatoethyl)-bicyclo[2.2.1]-heptane, and 1,3,5-tris(isocyanatomethyl)cyclohexane;

Monofunctional isocyanate monomers such as cyclohexyl isocyanate.

### Aromatic Isocyanate: Component (B1)

Difunctional isocyanate monomers such as xylylene diisocyanate (o-, m-, p-), tetrachloro-m-xylylene diisocyanate, methylenediphenyl-4,4'-diisocyanate, 4-chloro-m-xylylene diisocyanate, 4,5-dichloro-m-xylylene diisocyanate, 2,3,5,6-tetrabromo-p-xylylene diisocyanate, 4-methyl-m-xylylene diisocyanate, 4-ethyl-m-xylylene diisocyanate, bis(isocyanatoethyl)benzene, bis(isocyanatopropyl)benzene, 1,3-bis(α,α-dimethylisocyanatomethyl)benzene, 1,4-bis(α,α-dimethylisocyanatomethyl)benzene, α,α,α',α'-tetramethylxylylene diisocyanate, bis(isocyanatobutyl)benzene, bis(isocyanatomethyl)naphthalene, bis(isocyanatomethyl)diphenyl ether, bis(isocyanatoethyl) phthalate, 2,6-di(isocyanatomethyl)furan, phenylene diisocyanate (o-, m-, p-), tolylene diisocyanate, ethylphenylene diisocyanate, isopropylphenylene diisocyanate, dimethylphenylene diisocyanate, diethylphenylene diisocyanate, diisopropylphenylene diisocyanate, trimethylbenzene triisocyanate, benzene triisocyanate, 1,3,5-triisocyanatomethylbenzene, 1,5-naphthalene diisocyanate, methylnaphthalene diisocyanate, biphenyl diisocyanate, 2,4-tolylene diisocyanate, 2,6-tolylene diisocyanate, 4,4'-diphenylmethane diisocyanate, 2,2'-diphenylmethane diisocyanate, 2,4'-diphenylmethane diisocyanate, 3,3'-dimethyldiphenylmethane-4,4'-diisocyanate, bibenzyl-4,4'-diisocyanate, bis(isocyanatophenyl)ethylene, 3,3'-dimethoxybiphenyl-4,4'-diisocyanate, phenylisocyanatomethyl isocyanate, phenylisocyantoethyl isocyanate, tetrahydronaphthalene diisocyanate, hexahydrobenzene diisocyanate, hexahydrodiphenylmethane-4,4'-diisocyanate, diphenyl ether diisocyanate, ethylene glycol diphenyl ether diisocyanate, 1,3-propylene glycol diphenyl ether diisocyanate, benzophenone diisocyanate, diethylene glycol diphenyl ether diisocyanate, dibenzofuran diisocyanate, carbazole diisocyanate, ethylcarbazole diisocyanate, dichlorocarbazole diisocyanate, 2,4-tolylene diisocyanate, and 2,6-tolylene diisocyanate (corresponding to the difunctional polyiso(thio)cyanate group-containing monomer (B13) to constitute the urethane prepolymer (B12) to be mentioned in detail hereinunder);

Polyfunctional isocyanate monomers such as mesitylene triisocyanate, triphenylmethane triisocyanate, polymeric MDI, naphthalene triisocyanate, diphenylmethane-2,4,4'-triisocyanate, 3-methyldiphenylmethane-4,4',6-triisocyanate, and 4-methyl-diphenylmethane-2,3,4',5,6-pentaisocyanate;

Monofunctional isocyanate monomers such as phenyl isocyanate, 3-i-propenylcumyl isocyanate, 4-methoxyphenyl isocyanate, m-tolyl isocyanate, p-tolyl isocyanate, 1-naphthyl isocyanate, and dimethylbenzyl isocyanate.

### Isothiocyanate Compound; Component (B1)

Difunctional iso(thio)cyanate group-containing monomers such as p-phenylene diisothiocyanate, xylylene-1,4-diisothiocyanate, and ethylidyne diisothiocyanate (corresponding to the difunctional polyiso(thio)cyanate group-containing monomer (B13) to constitute the urethane prepolymer (B12) to be mentioned in detail hereinunder).

### Urethane Prepolymer (B12); urethane prepolymer having iso(thio)cyanate group at the terminal; Component (B1)

In the present invention, the urethane prepolymer (B12) prepared through reaction of the above-mentioned difunctional polyiso(thio)cyanate group-containing monomer (B13) and the difunctional poly(thi)ol (B32) to be mentioned hereinunder can also be used as the iso(thio)cyanate compound (B1).

For the urethane prepolymer (B12), though not specifically limited, monomers exemplified hereinunder are especially preferably used as the difunctional polyiso(thio)cyanate group-containing monomer (B13). Specifically, 1,5-naphthalene diisocyanate, xylylene diisocyanate (o-, m-, p-), 2,4-tolylene diisocyanate, 2,6-tolylene diisocyanate, phenylene diisocyanate (o-, m-, p-), 2,2'-diphenylmethane diisocyanate, 2,4'-diphenylmethane diisocyanate, and 4,4'-diphenylmethane diisocyanate are preferably used. Preferably, the difunctional poly(thi)ol (B32) is reacted with these to give the component (B12) having an iso(thio)cyanate groups at both terminals. Though not specifically limited, the weight-average molecular weight of the component (B12) is preferably 600 to 10000.

### Epoxy Group-Containing Monomer (B2); Component (B2)

The epoxy group-containing monomer is one having an epoxy group as a polymerizable group in the molecule, and is especially favorable in the case where a hydroxy group, an NH₂ group or an NCO group is introduced into the polyrotaxane monomer (A) as a polymerizable functional group therein.

Such an epoxy compound is roughly grouped into an aliphatic epoxy compound, an alicyclic epoxy monomer and an aromatic epoxy monomer, and preferred examples thereof usable herein are described in WO2015/068798.

### (Thi)ol Compound (B3)

The (thi)ol compound is a monomer having one or more substituents selected from the group consisting of an OH group and an SH group. Needless-to-say, a monomer having two of an OH group and an SH group can also be selected for use herein.

The (thi)ol compound is roughly grouped into an aliphatic alcohol, an alicyclic alcohol, an aromatic alcohol, a polyester polyol, a polyether polyol, a polycaprolactone polyol, a polycarbonate polyol, a polyacrylic polyol, a thiol, and an OH/SH-based polymerizable group-containing monomer. Specific examples of these are mentioned below.

### Aliphatic Alcohol; Component (B3)

Difunctional polyol monomers such as ethylene glycol, propylene glycol, dipropylene glycol, butylene glycol, 1,5-dihydroxypentane, 1,6-dihydroxyhexane, 1,7-dihydroxyheptane, 1,8-dihydroxyoctane, 1,9-dihydroxynonane, 1,10-dihydroxydecane, 1,11-dihydroxyundecane, 1,12-dihydroxydodecane, neopentyl glycol, glyceryl monooleate, monoelaidin, polyethylene glycol, 3-methyl-1,5-dihydroxypentane, dihydroxyneopentyl, 2-ethyl-1,2-dihydroxyhexane, and 2-methyl-1,3-dihydroxypropane (corresponding to the difunctional poly(thi)ol (B32) to constitute the urethane prepolymer (B12) mentioned above);

Polyfunctional polyol monomers such as glycerin, trimethylolethane, trimethylolpropane, ditrimethylolpropane, trimethylolpropane tripolyoxyethylene ether (e.g., TMP-30, TMP-60 and TMP-90 from Nippon Nyukazai Co., Ltd.), butanetriol, 1,2-methylglucoside, pentaerythritol, dipentaerythritol, tripentaerythritol, sorbitol, erythritol, threitol, ribitol, arabinitol, xylitol, allitol, mannitol, dulcitol, iditol, glycol, inositol, hexanetriol, triglycerol, diglycerol, and triethylene glycol;

### Alicyclic Alcohol: Component (B3)

Difunctional polyol monomers such as hydrogenated bisphenol A, cyclobutanediol, cyclopentanediol, cyclohexanediol, cycloheptanediol, cyclooctanediol, cyclohexanedimethanol, hydroxypropylcyclohexanol, tricyclo[5,2,1,0^{2,6}]decane-dimethanol, bicyclo[4,3,0]-nonanediol, dicyclohexanediol, tricyclo[5,3,1,1^{3,9}]dodecanediol, bicyclo[4,3,0]nonanedimethanol, tricyclo[5,3,1,1^{3,9}]dodecane-diethanol, hydroxypropyltricyclo[5,3,1,1^{3,9}]dodecanol, spiro[3,4]octanediol, butylcyclohexanediol, 1,1'-bicyclohexyhdenediol, 1,4-cyclohexanedimethanol, 1,3-cyclohexanedimethanol, 1,2-cyclohexanedimethanol, and o-dihydroxyxylylene (corresponding to the difunctional poly(thi)ol (B32) to constitute the urethane prepolymer (B12) mentioned above);

Polyfunctional polyol monomers such as tris(2-hydroxyethyl) isocyanurate, cyclohexanetriol, sucrose, maltitol, and lactitol.

### Aromatic Alcohol; Component (B3)

Difunctional polyol monomers such as dihydroxynaphthalane, dihydroxybenzene, bisphenol A, bisphenol F, xylylene glycol, tetrabromobisphenol A, bis(4-hydroxyphenyl)methane, 1,1-bis(4-hydroxyphenyl)ethane, 1,2-bis(4-hydroxyphenyl)ethane,bis(4-hydroxyphenyl)phenylmethane, bis(4-hydroxyphenyl)diphenylmethane, bis(4-hydroxyphenyl)-1-naphthylmethane, 1,1-bis(4-hydroxyphenyl)-1-phenylethane, 2-(4-hydroxyphenyl)-2-(3-hydroxyphenyl)propane, 2,2-bis(4-hydroxyphenyl)butane, 1,1-bis(4-hydroxyphenyl)butane, 2,2-bis(4-hydroxyphenyl)-3-methylbutane, 2,2-bis(4-hydroxyphenyl)pentane, 3,3-bis(4-hydroxyphenyl)pentane, 2,2-bis(4-hydroxyphenyl)hexane, 2,2-bis(4-hydroxyphenyl)octane, 2,2-bis(4-hydroxyphenyl)-4-methylpentane, 2,2-bis(4-hydroxyphenyl)heptane, 4,4-bis(4-hydroxyphenyl)heptane, 2,2-bis(4-hydroxyphenyl)tridecene, 2,2-bis(4-hydroxyphenyl)octane, 2,2-bis(3-methyl-4-hydroxyphenyl)propane, 2,2-bis(3-ethyl-4-hydroxyphenyl)propane, 2,2-bis(3-n-propyl-4-hydroxyphenyl)propane, 2,2-bis(3-isopropyl-4-hydroxyphenyl)propane, 2,2-bis(3-sec-butyl-4-hydroxyphenyl)propane, 2,2-bis(3-tert-butyl-4-hydroxyphenyl)propane, 2,2-bis(3-cyclohexyl-4-hydroxyphenyl)propane, 2,2-bis(3-allyl-4'-hydroxyphenyl)propane, 2,2-bis(3-methoxy-4-hydroxyphenyl)propane, 2,2-bis(3,5-dimethyl-4-hydroxyphenyl)propane, 2,2-bis(2,3,5,6-tetramethyl-4-hydroxyphenyl)propane, bis(4-hydroxyphenyl)cyanomethane, 1-cyano-3,3-bis(4-hydroxyphenyl)butane, 2,2-bis(4-hydroxyphenyl)hexafluoropropane, 1,1-bis(4-hydroxyphenyl)cyclopentane, 1,1-bis(4-hydroxyphenyl)cyclohexane, 1,1-bis(4-hydroxyphenyl)cycloheptane, 1,1-bis(3-methyl-4-hydroxyphenyl)cyclohexane, 1,1-bis(3,5-dimethyl-4-hydroxyphenyl)cyclohexane, 1,1-bis(3,5-dichloro-4-hydroxyphenyl)cyclohexane, 1,1-bis(3-methyl-4-hydroxyphenyl)-4-methylcyclohexane, 1,1-bis(4-hydroxyphenyl)-3,3,5-trimethylcyclohexane, 2,2-bis(4-hydroxyphenyl)norbornane, 2,2-bis(4-hydroxyphenyl)adamantane, 4,4'-dihydroxydiphenyl ether, 4,4'-dihydroxy-3,3'-dimethyldiphenyl ether, ethylene glycol bis(4-hydroxyphenyl) ether, 4,4'-dihydroxydiphenyl sulfide, 3,3'-dimethyl-4,4'-dihydroxydiphenyl sulfide, 3,3'-dicyclohexyl-4,4'-dihydroxydiphenyl sulfide, 3,3'-diphenyl-4,4'-dihydroxydiphenyl sulfide, 4,4'-dihydroxydiphenyl sulfoxide, 3,3'-dimethyl-4,4'-dihydroxydiphenyl sulfoxide, 4,4'-dihydroxydiphenyl sulfone, 4,4'-dihydroxy-3,3'-dimethyldiphenyl sulfone, bis(4-hydroxyphenyl) ketone, bis(4-hydroxy-3-methylphenyl) ketone, 7,7'-dihydroxy-3,3',4,4'-tetrahydro-4,4,4',4'-tetramethyl-2,2'-spirobi(2H-1-benzopyran), trans-2,3-bis(4-hydroxyphenyl)-2-butene, 9,9-bis(4-hydroxyphenyl)fluorene, 3,3-bis(4-hydroxyphenyl)-2-butanone, 1,6-bis(4-hydroxyphenyl)-1,6-hexanedione, 4,4'-dihydroxybiphenyl, m-dihydroxyxylylene, p-dihydroxyxylylene, 1,4-bis(2-hydroxyethyl)benzene, 1,4-bis(3-hydroxypropyl)benzene, 1,4-bis(4-hydroxybutyl)benzene, 1,4-bis(5-hydroxypentyl)benzene, 1,4-bis(6-hydroxyhexyl)benzene, 2,2-bis[4-(2"-hydroxyethyloxy)phenyl]propane, hydroquinone and resorcinol (corresponding to the difunctional poly(thi)ol (B32) to constitute the urethane prepolymer (B12) mentioned above);

Polyfunctional polyol monomers such as trihydroxynaphthalene, tetrahydroxynaphthalene, benzenetriol, biphenyltetraol, pyrogallol, (hydroxynaphthyl)pyrogallol, and trihydroxyphenanthrene.

### Polyester Polyol; Component (B3)

The polyester polyol includes a compound to be produced by condensation of a polyol and a polybasic acid. Above all, those having a number-average molecular weight of 400 to 2000 are preferred, those with 500 to 1500 are more preferred, and those with 600 to 1200 are most preferred. The compound having a hydroxy group at both ends alone of the molecule (having two hydroxy groups in the molecule) corresponds to the difunctional poly(thi)ol (B32) to constitute the urethane prepolymer (B12) mentioned above.

### Polyether Polyol; Component (B3)

The polyether polyol includes a compound to be produced by ring-opening polymerization of an alkylene oxide and a compound to be produced by reaction of a compound having 2 or more active hydrogen-containing groups in the molecule and an alkylene oxide, and a modified derivative thereof. Above all, those having a number-average molecular weight of 400 to 2000 are preferred, those with 500 to 1500 are more preferred, and those with 600 to 1200 are most preferred. The compound having a hydroxy group at both ends alone of the molecule (having two hydroxy groups in the molecule) corresponds to the difunctional poly(thi)ol (B32) to constitute the urethane prepolymer (B12) mentioned above.

### Polycaprolactone Polyol; Component (B3)

The polycaprolactone polyol includes a compound to be produced by ring-opening polymerization of an ε-caprolactone. Above all, those having a number-average molecular weight of 400 to 2000 are preferred, those with 500 to 1500 are more preferred, and those with 600 to 1200 are most preferred. The compound having a hydroxy group at both ends alone of the molecule (having two hydroxy groups in the molecule) corresponds to the difunctional poly(thi)ol (B32) to constitute the urethane prepolymer (B12) mentioned above.

### Polycarbonate Polyol; Component (B3)

The polycarbonate polyol includes a compound to be produced by phosgenation of one or more low-molecule polyols, and a compound to be produced by interesterification with ethylene carbonate, diethyl carbonate or diphenyl carbonate. Above all, those having a number-average molecular weight of 400 to 2000 are preferred, those with 500 to 1500 are more preferred, and those with 600 to 1200 are most preferred. The compound having a hydroxy group at both ends alone of the molecule (having two hydroxy groups in the molecule) corresponds to the difunctional poly(thi)ol (B32) to constitute the urethane prepolymer (B12) mentioned above.

### Polyacrylic Polyol; Component (B3)

The polyacrylic polyol includes a polyol compound to be produced by polymerization of a (meth)acrylate or a vinyl monomer. The compound having a hydroxy group at both ends alone of the molecule (having two hydroxy groups in the molecule) corresponds to the difunctional poly(thi)ol (B32) to constitute the urethane prepolymer (B12) mentioned above.

### Thiol; Component (B3)

Specific examples of the thiol are described in WO2015/068798, and these are usable here. Above all, especially preferred compounds are mentioned below.

Tetraethylene glycol bis(3-mercaptopropionate), 1,4-butanediol bis(3-mercaptopropionate), 1,6-hexanediol bis(3-mercaptopropionate), 1,4-bis(mercaptopropylthiomethyl)benzene (corresponding to the difunctional poly(thi)ol (B32) to constitute the urethane prepolymer (B12) mentioned above);

Thiol monomers such as trimethylolpropane tris(3-mercaptopropionate), pentaerythritol tetrakis(3-mercaptopropionate), dipentaerythritol hexakis(3-mercaptopropionate), 1,2-bis[(2-mercaptoethyl)thio]-3-mercaptopropane, 2,2-bis(mercaptomethyl)-1,4-butanedithiol, 2,5-bis(mercaptomethyl)-1,4-dithiane, 4-mercaptomethyl-1,8-dimercapto-3,6-dithiaoctane, 1,1,1,1-tetrakis(mercaptomethyl)methane, 1,1,3,3-tetrakis(mercaptomethylthio)propane, 1,1,2,2-tetrakis(mercaptomethylthio)ethane, 4,6-bis(mercaptomethylthio)-1,3-dithiane, and tris-{(3-mercaptopropionyloxy)ethyl}-isocyanurate.

### OH/SH-type Polymerizable Group-Containing Monomer; Component (B3)

2-Mercaptoethanol, 1-hydroxy-4-mercaptocyclohexane, 2-mercaptohydroquinone, 4-mercaptophenol, 1-hydroxyethylthio-3-mercaptoethylthiobenzene, 4-hydroxy-4'-mercaptodiphenyl sulfone, 2-(2-mercaptoethylthio)ethanol, dihydroxyethyl sulfide mono(3-mercaptopropionate), and dimercaptoethane mono(salicylate) (corresponding to the difunctional poly(thi)ol (B32) to constitute the urethane prepolymer (B12) mentioned above);

Poly(thi)ol monomers such as 3-mercapto-1,2-propanediol, glycerin di(mercaptoacetate), 2,4-dimercaptophenol, 1,3-dimercapto-2-propanol, 2,3-dimercapto-1-propanol, 1,2-dimercapto-1,3-butanediol, pentaerythritol tris(3-mercaptopropionate), pentaerythritol mono(3-mercaptopropionate), pentaerythritol bis(3-mercaptopropionate), pentaerythritol tris(thioglycolate), pentaerythritol pentakis(3-mercaptopropionate), hydroxymethyl-tris(mercaptoethylthiomethyl)methane, and hydroxyethyl thiomethyl-tris(mercaptoethylthio)methane.

### Amino Group-Containing Monomer (B4); Component (B4)

The amino group-containing monomer (B4) is a monomer having 1 or more primary or secondary amino groups, and is roughly grouped into an aliphatic amine, alicyclic amine, and an aromatic amine. Specific examples of these are mentioned below.

### Aliphatic Amine; Component (B4)

Polyamines such as ethylenediamine, hexamethylenediamine, nonamethylenediamine, undecamethylenediamine, dodecamethylenediamine, metaxylenediamine, 1,3-propanediamine, putrescin, and diethylenetriamine.

Monofunctional amines such as monoethylamine, n-propylamine, diethylamine, di-n-propylamine, n-propylamine, di-n-butylamine, and n-butylamine.

### Alicyclic Amine; Component (B4)

Polyamines such as isophoronediamine, and cyclohexyldiamine.

Monofunctional amines such as cyclohexylamine, and N-methylcyclohexylamine.

### Aromatic Amine; Component (B4)

Polyamines such as 4,4'-methylenebis(o-chloroaniline) (MOCA), 2,6-dichloro-p-phenylenediamine, 4,4'-methylenebis(2,3-dichloroaniline). 4,4'-methylenebis(2-ethyl-6-methylaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethylene glycol-di-p-aminobenzoate, polytetramethylene glycol-di-p-aminobenzoate, 4,4'-diamino-3,3',5,5'-tetraethyldiphenylmethane, 4,4'-diamino-3,3'-diisopropyl-5,5'-dimethyldiphenylmethane, 4,4'-diamino-3,3'-5,5'-tetraisopropyldiphenylmethane, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 3,3'-diethyl-4,4'-diaminodiphenylmethane, m-xylylenediamine, N,N'-di-sec-butyl-p-phenylenediamine, m-phenylenediamine, p-xylylenediamine, p-phenylenediamine, 3,3'-methylenebis(methyl-6-aminobenzoate), 2-methylpropyl 2,4-diamino-4-chlorobenzoate, isopropyl 2,4-diamino-4-chlorobenzoate, isopropyl 2,4-diamino-4-chlorophenylacetate, di(2-aminophenyl)thioethyl terephthalate, diphenylmethanediamine, tolylenediamine, piperazine, 1,3,5-benzenetriamine, and melamine.

Monofunctional amines such as benzylamine, and dibenzylamine.

### Curable Composition containing component (B1), component (B2), component (B3) and component (B4)

In the present invention, in the case of a curable composition containing the component (B1), the component (B2), the component (B3) and the component (B4), that is, in the case where the polymerizable functional group in the polyrotaxane monomer (A) is not a radical polymerizable group and the curable composition is polymerized and cured by polycondensation or addition polymerization to produce a cured product, preferably, the blending ratio of the components is as follows.

Specifically, relative to the total, 100 parts by mass, of the total amount of the component (B1), the component (B2), the component (B3) and the component (B4) (hereinafter may be simply referred to as "the total amount of the component (B)") and the amount of the component (A), it is preferable that the amount of the component (A) in the composition falls within a range of 3 to 50 parts by mass, and the total amount of the component (B) falls within a range of 50 to 97 parts by mass. When the composition contains the polyrotaxane monomer (A) at the ratio as above, and when the resultant cured product is for a polishing pad, the cured product can express excellent polishing characteristics and mechanical characteristics. In the case of a photochromic cured product containing a photochromic compound, the cured product can express excellent photochromic characteristics and mechanical characteristics. For achieving the above-mentioned effects, more preferably, the amount of the component (A) falls within a range of 5 to 45 parts by mass and the total amount of the component (B) falls within a range of 55 to 95 parts by mass.

Further, when the total amount of the component (B) is 100% by mass, it is preferable that the component (B1) accounts for 0 to 95% by mass, the component (B2) accounts for 0 to 100% by mass, the component (B3) accounts for 0 to 80% by mass, and the component (B4) accounts for 0 to 30% by mass for achieving excellent mechanical characteristics. For more effectively achieving the effect, more preferably, the component (B1) accounts for 20 to 95% by mass, the component (B2) accounts for 0 to 20% by mass, the component (B3) accounts for 0 to 70% by mass, and the component (B4) accounts for 0 to 25% by mass, even more preferably, the component (B1) accounts for 25 to 85% by mass, the component (B2) accounts for 0 to 5% by mass, the component (B3) accounts for 15 to 70% by mass, and the component (B4) accounts for 0 to 20% by mass.

Depending on the use of the polyrotaxane monomer of the present invention, the blending ratio can also be as follows. Specifically, for use for a polishing pad (for example, a CMP polishing pad), preferably, the component (B1) accounts for 40 to 85% by mass, the component (B2) accounts for 0 to 5% by mass, the component (B3) accounts for 0 to 35% by mass, and the component (B4) accounts for 0 to 20% by mass. For use for a photochromic cured product (for example, for use for an optical article such as eyeglass lenses), preferably, the component (B1) accounts for 25 to 65% by mass, the component (B2) accounts for 0 to 5% by mass, the component (B3) accounts for 35 to 70% by mass, and the component (B4) accounts for 0 to 15% by mass.

### Radical Polymerizable Monomer (B5)

The curable composition of the present invention may contain a radical polymerizable monomer (B5).

The radical polymerizable monomer (B5) (hereinafter may be simply referred to as component (B5)) is not specifically limited so far as it has a radical polymerizable group. The radical polymerizable monomer is roughly grouped into a (meth)acrylate group-having (meth)acrylate compound, a vinyl group-having vinyl compound, and an allyl group-having allyl compound.

Preferred examples of the radical polymerizable monomer (B5) are described in WO2015/068798, which can be used here. Among these, examples of the radical polymerizable compound especially favorably used in the present invention are compounds shown below, and these are especially favorably used in the present invention.

### (B51); (Meth)acrylate Compound

The (meth)acrylate compound (B51) (hereinafter may be simply referred to as "component (B51)") includes compounds represented by the following formulae (1) to (4).

### Monomer represented by formula (1) (B511); (Component (B51))

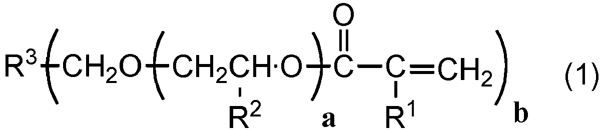

In the formula, R¹ represents a hydrogen atom or a methyl group, R² represents a hydrogen atom or an alkyl group having 1 to 2 carbon atoms, R³ represents a 3- to 6-valent organic group having 1 to 10 carbon atoms, a represents a number of 0 to 3 as an average value, b represents a number of 3 to 6. The alkyl group having 1 to 2 carbon atoms represented by R² is preferably a methyl group. The organic group represented by R³ includes a group derived from a polyol, a 3- to 6-valent hydrocarbon group, and a 3- to 6-valent urethane bond-containing organic group.

Examples of preferred compounds represented by the above formula (1) include:
trimethylolpropane trimethacrylate, and ditrimethylolpropane tetramethacrylate.

### Component (B512); Compound represented by formula (2), Component (B51)

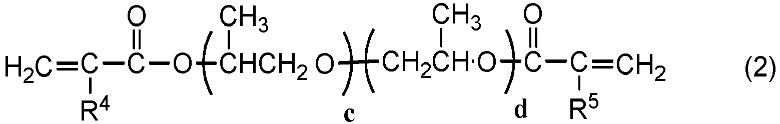

In the formula, R⁴ and R⁵ each represent a hydrogen atom or a methyl group, and c and d each represent an integer of 0 or more.

In the case where R⁴ and R⁵ are both methyl groups, c + d is 2 or more and less than 7 as an average value; in the case where R⁴ is a methyl group and R⁵ is a hydrogen atom, c + d is 2 or more and less than 5 as an average value; and in the case where R⁴ and R⁵ are both hydrogen atoms, c + d is 2 or more and less than 3 as an average value.

Examples of most preferred compounds of the above formula (2) include:
tripropylene glycol dimethacrylate, and tetrapropylene glycol dimethacrylate.

### Component (B513); Compound represented by formula (3), Component (B51)

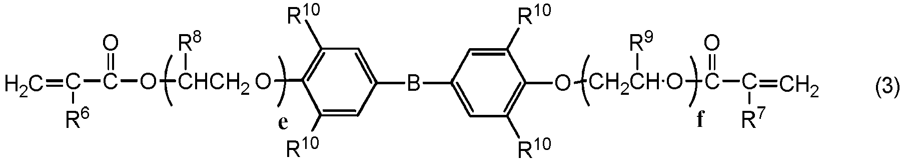

In the formula, R⁶ and R⁷ each represent a hydrogen atom or a methyl group, R⁸ and R⁹ each represent a hydrogen atom or a methyl group, R¹⁰ represents a hydrogen atom or a halogen atom, B represents any of -O-, -S-, - (SO₂)-, -CO-, -CH₂-, -CH=CH-,-C(CH₃)₂-, or -C(CH₃)(C₆H₅)-, e and f each represent an integer of 1 or more, e + f is 2 or more and 30 or less as an average value.

The polymerizable monomer represented by the above formula (3) is generally produced in the form of a mixture of molecules each having a different molecular weight. Consequently, e and f are expressed as an average value.

Examples of preferred monomers of the above formula (3) are shown below.

Bisphenol A dimethacrylate, 2,2-bis(4-methacryloyloxy(polyethoxy)phenyl]propane (e + f = 2.6), 2,2-bis[4-methacryloxy(polyethoxy)phenyl]propane (e + f = 10), 2,2-bis[4-methacryloxy(polyethoxy)phenyl]propane (e + f = 17), 2,2-bis[4-methacryloxy(polyethoxy)phenyl]propane (e + f = 30), 2,2-bis(3,5-dibromo-4-methacryloyloxyethoxyphenyl)propane, 2,2-bis(4-methacryloyloxydipropoxyphenyl)propane, bisphenol A diacrylate, 2,2-bis[4-acryloxy(polyethoxy)phenyl]propane (e + f = 10), and 2,2-bis[4-acryloxy(polyethoxy)phenyl]propane (e + f = 20).

### Component (B514); Compound represented by formula (4), Component (B51)

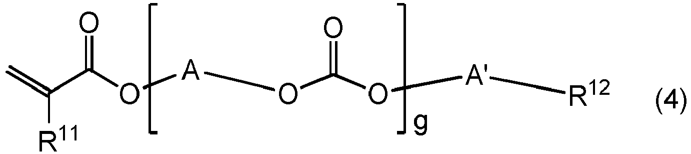

In the formula, g represents a number of 1 to 20 as an average value, A and A' may be the same as or different from each other, each representing a linear or branched alkylene group having 2 to 15 carbon atoms, when the formula has plural A's, the plural A's may be the same groups or different groups, R¹¹ represents a hydrogen atom or a methyl group, R¹² represents a (meth)acryloyloxy group or a hydroxy group.

The compound represented by the above formula (4) can be produced by reacting a polycarbonate diol and a (meth)acrylic acid.

A most preferred form of the above formula (4) is one produced by reacting a polycarbonate of a mixture of pentamethylene glycol and hexamethylene glycol having a number-average molecular weight of 500, and acrylic acid, and R¹² includes a monomer of an acryloyloxy group.

### Component (B515); Silsesquioxane Monomer; Component (B51)

A silsesquioxane monomer can have various molecular structures of cage-like, ladder-like or random structures, and is preferably one having a radical polymerizable group such as a (meth)acrylate group.

Examples of the silsesquioxane compound of the type include those represented by the following formula (5).

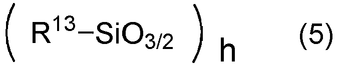

In the formula, h represents a polymerization degree, and is an integer of 3 to 100, plural R¹³'s may be the same as or different from each other, each representing a radical polymerizable group, an organic group containing a radical polymerizable group, a hydrogen atom, an alkyl group, a cycloalkyl group, an alkoxy group or a phenyl group, and at least one R¹³ is a radical polymerizable group or an organic group containing a radical polymerizable group.

Here, the radical polymerizable group or the organic group containing a radical polymerizable group represented by R¹³ includes a (meth)acrylate group; and an organic group having a (meth)acrylate group such as a (meth)acryloyloxypropyl group, or a (3-(meth)acryloyloxypropyl)dimethylsiloxy group.

### Component (B516); Other (meth)acrylate compounds, Component (B51)

Examples of other monomers than the compounds represented by the above formulae (1) to (4) are shown below.

Methoxypolyethylene glycol methacrylate (especially average molecular weight 293), methoxypolyethylene glycol methacrylate (especially average molecular weight 468), methoxypolyethylene glycol acrylate (especially average molecular weight 218), methoxypolyethylene glycol acrylate (especially average molecular weight 454), diethylene glycol dimethacrylate, triethylene glycol dimethacrylate, tetraethylene glycol dimethacrylate, pentaethylene glycol dimethacrylate, pentapropylene glycol dimethacrylate, diethylene glycol diacrylate, triethylene glycol diacrylate, tetraethylene glycol diacrylate, pentaethylene glycol diacrylate, tripropylene glycol diacrylate, tetrapropylene glycol diacrylate, pentapropylene glycol diacrylate, dimethacrylate which is a mixture of polypropylene glycol and polyethylene glycol (having a repeating unit of 2 polyethylenes and 2 polypropylenes), polyethylene glycol dimethacrylate (especially average molecular weight 330), polyethylene glycol dimethacrylate (especially average molecular weight 536), polytetramethylene glycol dimethacrylate (especially average molecular weight 736), tripropylene glycol dimethacrylate, tetrapropylene glycol dimethacrylate, polypropylene glycol dimethacrylate (especially average molecular weight 536), polyethylene glycol diacrylate (especially average molecular weight 258), polyethylene glycol diacrylate (especially average molecular weight 308), polyethylene glycol diacrylate (especially average molecular weight 508), polyethylene glycol diacrylate (especially average molecular weight 708), polyethylene glycol methacrylate acrylate (especially average molecular weight 536), (polyethylene glycol/polypropylene glycol) diacrylate copolymer (especially average molecular weight 330), ethoxylated cyclohexanedimethanol acrylate (especially average molecular weight 434), polyester oligomer hexaacrylate, caprolactone-modified dipentaerythritol hexaacrylate, 4-functional polyester oligomer (molecular weight 2500 to 3500, e.g., EB80 from Daicel UCB Corporation), 4-functional polyester oligomer (molecular weight 6000 to 8000, e.g., EB450 form Daicel UCB Corporation), 6-functional polyester oligomer (molecular weight 45000 to 55000, e.g., EB1830 from Daicel UCB Corporation), 4-functional polyester oligomer (especially molecular weight 10000, e.g., GX8488B from DKS Co., Ltd.), ethylene glycol bisglycidyl methacrylate, 1,4-butylene glycol dimethacrylate, 1,9-nonylene glycol dimethacrylate, neopentylene glycol dimethacrylate, bis(2-methacryloyloxyethylthioethyl) sulfide, bis(methacryloyloxyethyl) sulfide, bis(acryloyloxyethyl) sulfide, 1,2-bis(methacryloyloxyethylthio)ethane, 1,2-bis(acryloyloxyethyl)ethane, bis(2-methacryloyloxyethylthioethyl) sulfide, bis(2-acryloyloxyethylthioethyl) sulfide, 1,2-bis(methacryloyloxyethylthioethylthio)ethane, 1,2-bis(acryloyloxyethylthioethylthio)ethane, 1,2-bis(methacryloyloxyisopropylthioisopropyl) sulfide, 1,2-bis(acryloyloxyisopropylthioisopropyl) sulfide, stearyl methacrylate, lauryl methacrylate, methyl acrylate, ethyl acrylate, butyl acrylate, octyl acrylate, and lauryl acrylate;

Esters of (meth)acrylic acid, such as methyl (meth)acrylate, benzyl (meth)acrylate, phenyl (meth)acrylate, and 2-hydroxyethyl (meth)acrylate;

Esters of thioacrylic acid or thiomethacrylic acid, such as methyl thioacrylate, benzyl thioacrylate, and benzyl thiomethacrylate;

Polyfunctional urethane (meth)acrylates, such as U-4HA (molecular weight 596, number of functional groups 4), U-6HA (molecular weight 1019, number of functional groups 6), U-6LPA (molecular weight 818, number of functional groups 6), U-15HA (molecular weight 2300, number of functional groups 15), U-2PPA (molecular weight 482), UA-122P (molecular weight 1100) and U-122P (molecular weight 1100) from Shin-Nakamura Chemical Co., Ltd., EB4858 (molecular weight 454) from Daicel UCB Corporation, U-108A, U-200PA, UA-511, U-412A, UA-4100, UA-4200, UA-4400, UA-2235PE, UA-160TM, UA-6100, UA-6200, U-108, UA-4000, and UA-512 from Shin-Nakamura Chemical Co., Ltd., and UX-2201, UX3204, UX4101, 6101, 7101, and 8101 from Nippon Kayaku Co., Ltd.

### Component (B52); Vinyl Compound

The vinyl compound includes styrene, α-methylstyrene and α-methylstyrene dimer. The above-mentioned silsesquioxane monomers where R¹³ is a vinyl group, or a vinyl group-having organic group such as a vinylpropyl group or a vinyldimethylsiloxy group also correspond to the vinyl compound.

### Component (B53); Allyl Compound

The allyl compound includes methoxypolyethylene glycol allyl ether (especially average molecular weight 550), methoxypolyethylene glycol allyl ether (especially average molecular weight 350), and methoxypolyethylene glycol allyl ether (especially average molecular weight 1500). The above-mentioned silsesquioxane monomers where R¹³ is an allyl group, or an allyl group-having organic group such as a allylpropyl group or an allylpropyldimethylsiloxy group also correspond to the allyl compound.

### Other Radical Polymerizable Monomers (B54)

In the present invention, a composite polymerizable compound having plural kinds of polymerizable groups in the molecule is also usable. Specific examples of the compound are mentioned below. Here, any and every compound having one radical polymerizable group in the molecule is considered to fall within this category.

### Radical Polymerizable/Epoxy-type Polymerizable Group-Containing Monomer; Component (B54)

This includes glycidyl methacrylate, glycidyloxymethyl methacrylate, 2-glycidyloxyethyl methacrylate, 3-glycidyloxypropyl methacrylate, 4-glycidyloxybutyl methacrylate, polyethylene glycol glycidyl methacrylate, polypropylene glycol glycidyl methacrylate, bisphenol A-monoglycidyl ether methacrylate, polyethylene glycol glycidyl acrylate, and polyethylene glycol glycidyl acrylate.

### Radical Polymerizable/OH-type Polymerizable Group-Containing Monomer; Component (B54)

This includes 2-hydroxy methacrylate, 2-hydroxy acrylate, and 2-hydroxypropyl acrylate.

### Radical Polymerizable/Isocyanate Group-Containing Monomer; Component (B54)

This includes 2-isocyanatoethyl methacrylate, and 2-isocyanatoethyl acrylate.

### Radical Polymerizable/Silyl Group-Containing Monomer; Component (B54)

This includes γ-methacryloyloxypropyltrimethoxysilane, and γ-methacryloyloxypropylmethyldimethoxysilane.

Apart from the above-mentioned polymerizable monomers, any other polymerizable monomer is usable herein with no limitation. For example, an episulfide monomer, a thietanyl monomer and a mono(thi)ol monomer are usable. Preferred examples of the episulfide monomer, the thietanyl monomer and the mono(thi)ol monomer are described in WO2015/068798, and these are usable here.

### Curable Composition Containing Component (B5)

In the present invention, in a case where the curable composition containing a component (B5), in which, namely, the polymerizable functional group in the polyrotaxane monomer (A) is a radical polymerizable group, the blending ratio of the components therein is preferably as follows.

Specifically, it is preferable that, relative to 100 parts by mass of the total of the component (B5) and the component (A) in the composition, the amount of the component (A) is 2 to 50 parts by mass, and the total amount of the component (B5) is 50 to 98 parts by mass. Aphotochromic compound-containing photochromic cured product that contains the polyrotaxane monomer (A) in that ratio can express excellent photochromic characteristics and mechanical characteristics. For achieving the above-mentioned effects, more preferably, the amount of the component (A) is 3 to 40 parts by mass and the total amount of the component (B) is 60 to 97 parts by mass.

Further, relative to the total amount of the component (B5) of 100% by mass, preferably, the component (B51) accounts for 77 to 99% by mass, the component (B52) accounts for 0 to 15% by mass, the component (B53) accounts for 0 to 5% by mass, and the component (B54) accounts for 1 to 3% by mass, for the moldability for the cured product. For more effectively achieving the effect, more preferably, the component (B51) accounts for 85 to 99% by mass, the component (B52) accounts for 0 to 10% by mass, the component (B53) accounts for 0 to 3% by mass, and the component (B54) accounts for 1 to 2% by mass.

In the case where the above range is satisfied and where the total amount of the component (B51) is 100% by mass, it is preferable that the component (B511) accounts for 5 to 50% by mass, the component (B512) accounts for 0 to 60% by mass, the component (B513) accounts for 0 to 70% by mass, the component (B514) accounts for 0 to 20% by mass, the component (B515) accounts for 0 to 20% by mass and the component (B516) accounts for 10 to 70% by mass, for securing excellent photochromic characteristics. For more effectively exhibiting the effect, more preferably, the component (B511) accounts for 7 to 40% by mass, the component (B512) accounts for 0 to 50% by mass, the component (B513) accounts for 0 to 60% by mass, the component (B514) accounts for 0 to 15% by mass, the component (B515) accounts for 0 to 10% by mass and the component (B516) accounts for 15 to 60% by mass.

### Regarding Preferred Curable Composition

The curable composition of the present invention preferably contains the above-mentioned polyrotaxane monomer (A) and the polymerizable monomer (B). Preferably, the kind of the polymerizable monomer (B) is appropriately selected depending on the kind of the polymerizable functional group that the polyrotaxane monomer has.

For example, when the polyrotaxane monomer contains a hydroxy group, preferably, the polymerizable monomer (B) contains an iso(thio)cyanate compound (B1).

In the case where the polyrotaxane monomer contains a hydroxy group, more preferably, the polymerizable monomer (B) contains, in addition to the iso(thio)cyanate compound (B1), at least one monomer selected from an epoxy group-containing monomer (B2), a (thi)ol compound (B3) and an amino group-containing monomer (B4).

In the case where the polyrotaxane monomer contains a hydroxy group, even more preferably, the polymerizable monomer (B) contains, in addition to the iso(thio)cyanate compound (B1), at least one monomer selected from a (thi)ol compound (B3) and an amino group-containing monomer (B4).

As opposed to this, in the case where the polyrotaxane monomer (A) contains a radical polymerizable group such as a (meth)acrylate group, the polymerizable monomer (B) preferably contains a radical polymerizable monomer (B5). For example, in the case where the polymerizable functional group of the polyrotaxane monomer (A) contains a (meth)acrylate group, the polymerizable monomer (B) is preferably a (meth)acrylate compound.

The above polyrotaxane monomer (A) and the other polymerizable monomer (B) than polyrotaxane can be appropriately selected depending on the intended use. For example, in the case where a photochromic curable composition is prepared, the polymerizable functional group of the polyrotaxane monomer (A) is preferably selected from an OH group, an SH group or a radical polymerizable group, and the polymerizable monomer (B) is preferably selected from an iso(thio)cyanate compound (B1) and a radical polymerizable monomer (B5). In the case where the polymerizable functional group of the polyrotaxane monomer (A) is an OH group or an SH group, also preferably, a (thi)ol compound (B3) is used concurrently in addition to the iso(thio)cyanate compound (B1). In that manner, excellent mechanical properties and photochromic characteristics can be expressed. Among the above, the case where an iso(thio)cyanate compound (B1) is used as the polymerizable monomer (B) can achieve an especially superior effect in the present invention.

For use for a polishing pad material, preferably, an OH group is selected for the polymerizable functional group of the polyrotaxane monomer (A), and also preferably, an iso(thio)cyanate compound (B1) is selected for the polymerizable monomer (B). In particular, for use for a polishing pad material, preferably, an urethane prepolymer (B12) is selected from among the iso(thio)cyanate compound (B1). In that manner, the mechanical characteristics of the resultant polishing pad material can be improved, and the polishing pad material can express especially good wear resistance characteristics.

The water content in the polymerizable monomer (B) to be used is preferably 3000 ppm or less. This can bring about the advantageous effects of the present invention more efficiently. The lower limit of the water content in the polymerizable monomer (B) is, though not specifically limited, preferably 50 ppm, more preferably 10 ppm.

### (Other formulation ingredients to be blended in curable composition)

A variety of polymerization curing accelerators (C) may be used in the curable composition of the present invention for rapidly accelerating polymerization and curing the composition, depending on the kind of the polymerizable functional group introduced into the above-mentioned polyrotaxane monomer (A) and the polymerizable monomer (B).

### (C) Polymerization Curing Accelerator

For example, in the case where the polymerizable functional group that the polyrotaxane monomer (A) has is a polymerizable group such as an OH group, an amino group, an epoxy group or an SH group, and where the component (B) is selected from an iso(thio)cyanate compound (B1), a reaction catalyst for urethane or urea (C1) or a condensing agent (C2) is used as a polymerization curing accelerator.

In the case where the polymerizable functional group that the polyrotaxane monomer (A) has is a polymerizable functional group such as an OH group, an amino group or an NCO group, and where the component (B) is selected from an epoxy group-containing monomer (B2), an episulfide monomer and a thietanyl monomer, an epoxy curing agent (C3) or a cation polymerization catalyst (C4) for ring-opening polymerization of an epoxy group is used as a polymerization curing accelerator.

In the case where the polymerizable functional group that the polyrotaxane monomer (A) has is an NCO group or an NCS group, and where the component (B) is selected from a (thi)ol compound (B3) and an amino group-containing monomer (B4), a reaction catalyst for urethane or urea (C 1) or a condensing agent (C2) is used as a polymerization curing accelerator.

In the case where the polymerizable functional group that the polyrotaxane monomer (A) has is a radical polymerizable group, and where the component (B) is selected from a radical polymerizable monomer (B5), a radical polymerization initiator (C5) is used as a polymerization curing accelerator.

Specific examples of the above-mentioned polymerization accelerators (C1) to (C5) favorably used in the present invention are described in WO2015/068798.

One kind alone or two or more kinds of these various polymerization curing accelerators (C) can be used either singly or as combined, and the amount thereof to be used may be a so-called catalytic amount, and may be a small amount of, for example, 0.001 to 10 parts by mass, especially 0.01 to 5 parts by mass, relative to 100 parts by mass of the total of the polyrotaxane (A) and the polymerizable monomer (B).

### Photochromic Compound (D)

A photochromic compound (D) may be further blended in the above-mentioned curable composition. Specifically, there may be provided a photochromic curable composition containing the above-mentioned curable composition and a photochromic compound (D).

In other words, the cured product produced by curing the curable composition of the present invention may contain a photochromic compound (D) therein depending on the intended use of the cured product. For such use, a photochromic cured product produced by curing a photochromic curable composition is known. The photochromic cured product can be favorably used as photochromic eyeglasses. As the photochromic compound, any known photochromic compound can be used, and in the case of use as a photochromic composition, a chromene compound having an indeno[2,1-f]naphtho[1,2-b]pyran skeleton is preferably used from the viewpoint of coloration density, initial colorability, durability and decoloring speed, and in particular, a chromene compound having a molecular weight of 540 or more is favorably used as excellent in coloration density and decoloring speed.

One kind alone or two or more kinds of these various photochromic compounds (D) can be used either singly or as combined. The amount thereof to be used may be appropriately determined depending on the intended use, and, for example, preferably falls within a range of 0.001 to 20 parts by mass, especially 0.01 to 10 parts by mass relative to 100 parts by mass of the total of the polyrotaxane (A) and the polymerizable monomer (B).

The curable composition of the present invention can contain, in addition to the above, any known various ingredients within a range not detracting from the advantageous effects of the present invention. For example, abrasive grains, an antioxidant, a UV absorbent, an IR absorbent, a discoloring inhibitor, a fluorescent dye, a dye, a pigment, a perfume, a surfactant, a flame retardant, a plasticizer, a filler, an antistatic agent, a foam stabilizer, an antifoaming agent, a solvent, a leveling agent, and any other additives may be added to the composition. One alone or two or more kinds of these additives may be used either singly or as combined. These additives can be contained in the curable composition, and can be contained in the cured product by polymerizing the curable composition. Specifically, the abrasive grains include grains of a material selected from cerium oxide, silicon oxide, alumina, silicon carbide, zirconia, iron dioxide, manganese oxide, titanium oxide and diamond, or grains of two or more kinds of these materials.

A known method is employable for polymerizing the composition. For polycondensation or addition polymerization, the conditions described in WO2015/068798, WO2016/143910 and JP 2017-48305 A can be employed. For radical polymerization, the conditions described in WO2014/136804 and WO2015/068798 can be employed.

### <Cured Product>

The cured product in the present invention has a structure containing a polyrotaxane and an optional component of a photochromic compound dispersed in a matrix resin. For the matrix resin, various resins of a (thio)urethane resin and a (meth)acrylic resin can be selected depending on the kind of the polymerizable monomer (B).

For example, in the case where the polyrotaxane monomer (A) contains a hydroxy group and where the polymerizable monomer (B) contains an iso(thio)cyanate compound (B1), the cured product formed by curing the curable composition has a structure where a polyrotaxane has been dispersed in a (thio)urethane resin. In such a case, when the water content of the polyrotaxane monomer (A) to be blended in the curable composition is 5000 ppm or less, a cured product having an excellent appearance can be produced and the productivity thereof improves. In the case where a photochromic compound (D) is used, that is, where a polyrotaxane and a photochromic compound are dispersed in a (thio)urethane resin, the cured product can have an excellent appearance and the coloring density thereof can be high, when the water content in the polyrotaxane monomer (A) is 5000 ppm or less. Though not clear, the reason will be because the water content in the polyrotaxane monomer (A) is low, and therefore a photochromic compound can readily exist around the polyrotaxane and, as a result, the resultant cured product can readily color.

In the case of a polishing pad to be produced by curing the curable composition, when the water content of the polyrotaxane monomer (A) contained in the composition is 5000 ppm or less, the cured product can have an excellent appearance and can exhibit excellent polishing pad characteristics.

On the other hand, in the case where the polyrotaxane monomer (A) contains a radical polymerizable group such as a (meth)acrylate group, the polymerizable monomer (B) preferably contains a radical polymerizable monomer (B5). In the case where a radical polymerizable monomer is used as the polymerizable monomer (B), the storage stability of the curable composition improves when the water content in the polyrotaxane monomer (A) is 5000 ppm or less, and accordingly, for example, even when a photochromic compound is contained in the curable composition and the composition is stored for a long period of time, the photochromic characteristics of the photochromic cured product can be kept good.

In the case where the curable composition contains a photochromic compound (D), the composition can be polymerized and cured directly as it is to produce a photochromic cured product.

The cured product produced by curing the curable composition of the present invention may have pores formed therein, depending on the use thereof. As the use of the product, a polishing pad is known. Any known foaming method is employable with no limitation for forming pores in a polishing pad. Examples of the method include a method of dispersing a volatile foaming agent such as a low-boiling point hydrocarbon, or a hollow particles such as micro-hollow balloons in the composition and curing the composition, a method of mixing thermally expandable fine particles in the composition and then foaming the fine particles by heating, and a mechanical floss foaming method of blowing an inert gas such as air or nitrogen into a mixture. In the foaming case, the density of the matrix resin such as an urethane resin is preferably 0.4 to 0.9 g/cm³. In the case where a curable composition that can form an urethane bond is used for the cured product of the present invention, a foaming method with a foaming agent that includes adding water can also be employed. Also in the case where an urethane bond-formable curable composition is used in the present invention, the water content in the polyrotaxane monomer is controlled to be 5000 ppm or less, and thus, an desired foaming ratio can be achieved.

### <Cured Product containing hollow particles>

In the case where the cured product of the curable composition of the present invention is used for a polishing pad, preferably, the cured product contains hollow particles such as the above-mentioned microballoons. Specifically, it is desirable that the curable composition containing hollow particles is polymerized and cured to produce a hollow particles-containing cured product. Here, the matrix resin in the cured product is preferably an urethane resin, and the curable composition to produce the cured product is preferably a curable composition that can form an urethane resin.

Known hollow particles are usable here with no specific limitation. Preferably, hollow particles are formed of a shell part and a hollow part surrounded by the shell part. The shell part is generally formed of a resin, and specific examples thereof include a vinylidene chloride resin, a (meth)acrylic resin, a copolymer of an acrylic monomer and vinylidene chloride, a copolymer of acrylonitrile and vinylidene chloride, an epoxy resin, a phenolic resin, a melamine resin, and an urethane-based resin. Above all, the shell part of the hollow particles is preferably formed of an urethane-based resin. Specifically, the hollow particles are composed of a shell part formed of an urethane-based resin and a hollow part surrounded by the shell part. The urethane-based resin is a resin containing an urethane bond and/or an urea bond. In the case where the hollow particles are used, a uniform foam can be efficiently and easily produced, and the resultant foam hardly has defects such as scratches and the hysteresis loss thereof can be reduced.

Further, the hollow particles may have a hydrophilic group. For example, when the cured product of the curable composition of the present invention where the matrix resin is an urethane resin is used as a polishing pad, and when the hollow particles have a hydrophilic group, the resultant cured product can achieve good compatibility with a polishing slurry, and the polishing characteristics thereof can be thereby improved. The hydrophilic group may be a hydroxy group, a thiol group or an ionic group (group capable of forming at least one ion selected from the group consisting of a carboxylate ion, a sulfonate ion, a phosphate ion, a phosphonate ion, and a quaternary ammonium cation).

Though not specifically limited, the average particle size of the hollow particles preferably falls within the range mentioned below. Specifically, the average particle size is preferably 1 pm to 500 µm, more preferably 5 pm to 200 µm.

Also though not specifically limited, the density of the hollow particles preferably falls within the following range. Specifically, the density is preferably 0.01 g/cm³ to 0.5 g/cm³, more preferably 0.02 g/cm³ to 0.3 g/cm³. The density is a density of an expanded hollow particles. For unexpanded particles that are expanded by the heat in curing the curable composition mixed with the particles, preferably, the density of the particles after expansion falls within the above-mentioned range.

The blending amount of the hollow particles can be appropriately determined depending on the intended use. Specifically, as not indispensable, hollow particles may not be contained. In the case where hollow particles are contained, preferably, the blending amount thereof is as follows, based on the total amount of the monomer components. The total amount of the monomer components means a total amount of the component (A) and the component (B). The blending amount of the hollow particles is preferably 0.001 parts by mass or more and 20 parts by mass or less relative to 100 parts by mass of the total amount of the monomer components. Further, for expressing more excellent effects by blending hollow particles, the blending amount is especially preferably as follows. Specifically, the amount is preferably 0.02 parts by mass or more and 20 parts by mass or less relative to 100 parts by mass of the total amount of the monomer components, more preferably 0.03 parts by mass or more and 10 parts by mass or less.

### <Characteristics and Blending Agents in use for polishing pad>

In the case where the present invention is applied to a polishing pad, the cured product of the present invention can have an arbitrary suitable hardness. The hardness can be measured according to a Shore method, and for example, can be measured according to JIS K6253 (hardness test). When the cured product of the present invention is used for a polishing pad, preferably, it has a Shore hardness of 20A to 90D. Further, the Shore hardness is preferably 30A to 70D, more preferably 40A to 50D. ("A" indicates a hardness with a Shore "A" scale, and "D" indicates a hardness with a Shore "D" scale.) Specifically, when the cured product of the present invention is used as a polishing pad, the Shore A hardness thereof is preferably 20 or more, more preferably, the Shore A hardness is 30 or more, even more preferably the Shore A hardness is 40 or more, and preferably, the Shore D hardness thereof is 90 or less, more preferably the Shore D hardness is 70 or less, even more preferably the Shore D hardness is 50 or less. Regarding the hardness, the cured product can have any arbitrary hardness by changing the blending composition and the blending ratio, as needed.

When the cured product of the curable composition of the present invention is used for a polishing pad, preferably, the compressibility of the cured product falls within a predetermined range for the purpose of expressing the planarity of polished substances. The compressibility can be measured, for example, according to the method of JIS L1096. When the cured product of the present invention is used for a polishing pad, preferably, the compressibility thereof is 0.5% to 50%. When the compressibility falls within the range, the polishing pad of the cured product can express excellent planarity of polished substances.

When the cured product of the curable composition of the present invention is used for a polishing pad, preferably, the hysteresis loss of the cured product is 60% or less, more preferably 50% or less, even more preferably 40% or less. Hysteresis loss can be measured according to the method of JIS K6251. Specifically, a dumbbell-like prepared test piece is elongated by 100% and then restored to the original to measure the hysteresis loss thereof (area of elongation and stress in elongation and restoration to the original/area of elongation and stress in elongation × 100). When the hysteresis loss is low, it is presumed that, in use as a polishing pad, the kinetic energy of abrasive grains can be uniformly used in polishing the substance to be polished, and therefore an excellent planarity and a high polishing rate can be expressed. Further, when the hysteresis loss is low, it is considered that even a soft pad can express an excellent polishing rate.

When the present invention is applied to a polishing pad, the polishing pad may have plural polishing layers. For example, in the case where the cured product of the present invention is formed of two layers, the two layers may be polishing layers of a first layer that has a polishing surface to be in contact with a substance to be polished in polishing, and a second layer that is in contact with the first layer on the side opposite to the polishing surface of the first layer. In this case, the second layer may be made to have a hardness and an elastic modulus differing from those of the first layer to thereby control the physical properties of the first layer. For example, by varying the hardness of the first layer and the hardness of the second layer, the polishing performance on the substance to be polished can be controlled.

As described hereinabove, the cured product of the present invention may be made to contain abrasive grains as a constituent element inside it to be a so-called fixed abrasive grain cured product. Examples of the abrasive grains include grains formed of a material selected from cerium oxide, silicon oxide, alumina, silicon carbide, zirconia, iron oxide, manganese dioxide, titanium oxide and diamond, and two or more kinds of grains formed of these materials. Further, the abrasive grains for use herein may be surface-modified. For example, in the case where the cured product of the present invention is used as a polishing pad, abrasive grains whose surfaces have been modified with a hydrophilic group can be used to improve the compatibility thereof with a polishing slurry or water and to improve the polishing characteristics. The hydrophilic group includes a hydroxy group, a thiol group and an ionic group (group capable of forming at least one ion selected from the group consisting of a carboxylate ion, a sulfonate ion, a phosphate ion, a phosphonate ion and a quaternary ammonium ion). A fixing method for the abrasive grains is not specifically limited. For example, after abrasive grains have been dispersed in the above-mentioned curable composition, the curable composition may be cured to fix the abrasive grains inside the urethane resin therein.

In the case where the present invention is applied to a polishing pad, a grooved structure may be formed on the surface of the pad, though not specifically limited. The grooved structure is not specifically limited so far as it can keep and renew a slurry in polishing a substance to be polished, and examples thereof include an X (stripe) groove, an XY lattice groove, a concentric groove, a through-hole, a non-penetrating hole, a polygonal pillar, a columnar pillar, a helical groove, an eccentric groove, a radial groove, and a combination of these.

A method for forming the grooved structure is not specifically limited, and examples thereof include a mechanical cutting method using a tool such as a turning tool having a predetermined size, a method of casting a resin into a mold having a predetermined surface profile and curing it, a method of pressing a resin with a pressing plate having a predetermined surface profile, a photolithographic method, a printing method, and a method using a laser light such as a carbon dioxide laser.

Regarding use of the cured product of the present invention, for example, the curable composition capable of forming an urethane resin of the present invention is infiltrated into a nonwoven fabric, and then cured to give a nonwoven fabric urethane resin polishing pad for use herein. The cured product of the present invention having an urethane resin as a matrix resin can also be used as a buffer material, a damping material and a sound-absorbing material, in addition to the above-mentioned polishing pad. Further, by applying or infiltrating the curable composition of the present invention to or into a nonwoven fabric, and then curing it, the resultant product can also be used as the above-mentioned nonwoven fabric polishing pad, and also as a buffer material, a damping material and a sound-absorbing material.

### Examples

Next, the present invention is described in detail with reference to Examples and Comparative Examples, but the present invention is not restricted to the present Examples. First, the measurement devices used in the present invention and the production methods for the constituent components are described.

### (Measurement of Molecular Weight: Gel Permeation Chromatography (GPC Measurement)

For GPC measurement, a liquid chromatography system (from Waters Corporation) was used. With regard to columns, Shodex GPC KF-802 (exclusion limit molecular weight: 5,000), KF-802.5 (exclusion limit molecular weight: 20,000), KF-803 (exclusion limit molecular weight: 70,000), KF-804 (exclusion limit molecular weight: 400,000), and KF-805 (exclusion limit molecular weight: 2,000,000) all from Showa Denko K.K. were appropriately used in accordance with the molecular weight of the samples to be analyzed. Dimethylformamide (DMF) was used as a developing liquid and measurement was performed under the conditions at a flow rate of 1 mL/min and at a temperature of 40°C. Polystyrene was used as a reference sample and a weight average molecular weight was determined by comparison and conversion. As a detector, a differential refractometer was used.

### (Measurement of Water Content)

The water content was measured according to a Karl Fischer method. The apparatus used for the measurement and the measurement condition are as follows.
Apparatus: Automatic Water Determination Apparatus KF-31 (from Mitsubishi Chemical Analytic Corporation).
System: Karl Fischer titration system.
Titration Reagent: Aquamicron Titrant SS-Z (from Mitsubishi Chemical Corporation).
Solvent: Aquamicron dewatering solvent KTX (from Mitsubishi Chemical Corporation).

### Production Method for Polyrotaxane Monomer

### <Example 1>

### (1-1) Preparation of PEG-COOH;

Linear polyethylene glycol (PEG) having a molecular weight of 10,000 was prepared as a polymer for forming an axial molecule.
The following formulation was prepared;
PEG 10 g
TEMPO (2,2,6,6-tetramethyl-1-piperidinyloxy radical) 100 mg
Sodium bromide 1 g

The components were dissolved in 100 mL of water. To the resultant solution, 5 mL of a commercially available aqueous sodium hypochlorite solution (effective chlorine concentration: 5%) was added and stirred at room temperature for ten minutes. Thereafter, ethanol was added in an amount of up to 5 mL to terminate the reaction. This was extracted with 50 mL of methylene chloride, and thereafter methylene chloride was evaporated away. The resultant residue was dissolved in 250 mL of ethanol, and reprecipitated at a temperature of -4°C taking 12 hours to collect PEG-COOH, which was then dried.

### (1-2) Preparation of Polyrotaxane;

3 g of PEG-COOH prepared above and 12 g of α-cyclodextrin (a-CD) were separately dissolved in 50 mL of hot water at 70° C, and the resultant solutions were mixed and thoroughly shaken. Then, the mixed solution was reprecipitated at a temperature of 4° C for 12 hours, and the precipitated clathrate complex was freeze-dried and collected. Thereafter, 0.13 g of adamantanamine was dissolved in 50 mL of dimethylformamide (DMF) at room temperature, and the above clathrate complex was added and thoroughly mixed by quickly shaking. Subsequently, a solution prepared by dissolving 0.38 g of a BOP reagent (benzotriazol-1-yl-oxy-tris(dimethylamino)phosphonium hexafluorophosphate) in DMF was further added and thoroughly mixed by shaking. Further, a solution prepared by dissolving 0.14 mL of diisopropylethylamine in DMF was added and thoroughly mixed by shaking, to give a slurry reagent.

The slurry reagent prepared above was left to stand at 4° C for 12 hours. Thereafter, 50 mL of a DMF/methanol mixed solvent (volume ratio: 1/1) was added, mixed, and centrifuged, and the supernatant was removed. Further, this was washed with the above DMF/methanol mixed solution, then washed with methanol and centrifuged to give a precipitate. The resultant precipitate was vacuum-dried and thereafter dissolved in 50 mL of DMSO (dimethylsufloxide), and the resultant transparent solution was added dropwise to 700 mL of water to allow polyrotaxane to precipitate. The precipitated polyrotaxane was collected by centrifugation and was vacuum-dried. The dried polyrotaxane was further dissolved in DMSO, precipitated in water, collected and dried to give a purified polyrotaxane. At that time, the clathrating number of α-CD was 0.25.

Here, the polyrotaxane was dissolved in DMSO-d₆ and the resultant solution was analyzed with a ¹H-NMR measuring instrument (JNM-LA500 from JEOL Ltd.). The clathrating number was calculated by the method below.

Here, X, Y and X/(Y-X) mean as follows.
X: Integrated value of protons derived from the hydroxy groups of cyclodextrin at 4 to 6 ppm.
Y: Integrated value of protons derived from methylene chains of cyclodextrin and PEG at 3 to 4 ppm.

### X/(Y-X): Proton ratio of cyclodextrin to PEG.

First, X/(Y-X) when the maximum clathrating number was regarded as 1 was theoretically calculated and the resultant value was compared with X/(Y-X) calculated from the actual analysis value of the compound, and thereby the clathrating number was calculated.

### (1-3) Introduction of Side Chains into Polyrotaxane;

500 mg of the polyrotaxane purified above was dissolved in 50 mL of an aqueous 1 mol/L NaOH solution, and 3.83 g (66 mmol) of propylene oxide was added and stirred in an argon atmosphere at room temperature for 12 hours. Then, the polyrotaxane solution was neutralized so as to have a pH value of 7 to 8 using an aqueous 1 mol/L HCl solution, and the neutralized polyrotaxane solution was dialyzed through a dialysis tube and thereafter freeze-dried to give a hydroxypropylated polyrotaxane. The resultant hydroxylpropylated polyrotaxane was identified by ¹H-NMR and GPC and was thereby confirmed to be a hydroxylpropylated polyrotaxane having the intended structure.

The degree of modification of OH groups in the cyclic molecules with the hydroxypropyl groups was 0.5, and the weight-average molecular weight Mw measured by GPC was 50,000.

5 g of the resultant hydroxypropylated polyrotaxane was dissolved in 15 g of ε-caprolactone at 80°C to prepare a mixed solution. The mixed solution was stirred at 110°C for one hour while dry nitrogen was blown thereinto, and 0.16 g of a 50 wt % xylene solution of tin (II) 2-ethylhexanoate was added and stirred at 130°C for 6 hours. Thereafter, xylene was added to give a side chain-introduced polycaprolactone-modified polyrotaxane xylene solution having a nonvolatile concentration of approximately 35% by mass.

### (1-4) Preparation of OH Group-Introduced Side Chain-Modified Polyrotaxane (RX);

The polycaprolactone-modified polyrotaxane xylene solution prepared above was added dropwise to hexane and the resultant product was collected and dried to give a polycaprolactone-modified polyrotaxane (RX). (RX) is a polyrotaxane monomer corresponding to Comparative Example 1 given below.

### (1-5) Water content-Reducing Step (RX-1);

Subsequently, 10 g of the prepared polyrotaxane monomer (RX) was dissolved in 30 g of toluene and subjected to azeotropic dehydration, and then the collected sample was vacuum-dried to control the water content therein. Thus, a side-chain modified polyrotaxane (RX-1) having side chains terminated with an OH group was produced.

The physical properties of this polyrotaxane monomer (A); RX-1 are as described below.
Weight-average molecular weight Mw of polyrotaxane (GPC): 200,000.
Degree of side-chain modification: 0.5 (by percentage, 50%).
Molecular weight of side chain: approximately 350 on average.
Water content: 500 ppm.
Clathrating number of cyclic molecules: 0.25.

This polyrotaxane monomer (A) has an adamantyl group at both ends of the axial molecule and has a hydroxy group at the end of each side chain. The results are summarized in Table 1.

### <Example 2>

A polyrotaxane monomer was produced according to the same method as in Example 1, except that, in the water content-reducing step (1-5) in Example 1, the amount of toluene used was changed to 10 g. The physical properties of this polyrotaxane (A); RX-2 are as described below.
Weight-average molecular weight Mw of polyrotaxane (GPC): 200,000.
Degree of side-chain modification: 0.5 (by percentage, 50%).
Molecular weight of side chain: approximately 350 on average.
Water content: 3000 ppm.
Clathrating number of cyclic molecules: 0.25.

This polyrotaxane monomer (A) has an adamantyl group at both ends of the axial molecule and has a hydroxy group at the end of each side chain. The results are summarized in Table 1.

### <Example 3>

A polyrotaxane monomer was produced according to the same method as in Example 1, except that, in the water content-reducing step (1-5) in Example 1, the amount of toluene used was changed to 5 g. The physical properties of this polyrotaxane (A); RX-3 are as described below.
Weight-average molecular weight Mw of polyrotaxane (GPC): 200,000.
Degree of side-chain modification: 0.5 (by percentage, 50%).
Molecular weight of side chain: approximately 350 on average.
Water content: 5000 ppm.
Clathrating number of cyclic molecules: 0.25.

This polyrotaxane monomer (A) has an adamantyl group at both ends of the axial molecule and has a hydroxy group at the end of each side chain. The results are summarized in Table 1.

### <Example 4>

A polyrotaxane monomer was produced according to the same method as in Example 1, except that in Example 1, the molecular weight of the linear polyethylene glycol was changed to 35000, and the amount of ε-caprolactone was changed to 30 g. The physical properties of this polyrotaxane (A); RX-4 are as described below.
Weight-average molecular weight Mw of polyrotaxane (GPC): 700,000.
Degree of side-chain modification: 0.5 (by percentage, 50%).
Molecular weight of side chain: approximately 500 on average.
Water content: 800 ppm.
Clathrating number of cyclic molecules: 0.25.

This polyrotaxane monomer (A) has an adamantyl group at both ends of the axial molecule and has a hydroxy group at the end of each side chain. The results are summarized in Table 1.

### <Example 5>

### Preparation of Acrylate Group-Introduced Side Chain-Modified Polyrotaxane Monomer

The polycaprolactone-modified polyrotaxane (RX-4) prepared in the above Example 4 was used. 10.0 g of the polycaprolactone-modified polyrotaxane (RX-4) was dissolved in 50 mL of methyl ethyl ketone, 5 mg of dibutylhydroxytoluene (polymerization inhibitor) was added thereto, and 1.94 g of 2-acryloyloxyethyl isocyanate was thereafter added dropwise. 10 mg of dibutyltin dilaurate was added as a catalyst, and the resultant mixture was stirred at 70°C for 4 hours to give a methyl ethyl ketone solution of a polyrotaxane in which an acrylate group was introduced into the polycaprolactone end. The solution was added dropwise to hexane, and precipitated solids were collected. The collected sample was spread flatly, and dried under reduced pressure at 50°C for 24 hours to give a polyrotaxane monomer (RX-5) having an acrylate group introduced into the side chain as a radical polymerizable group.

The physical properties of the polyrotaxane monomer (A); RX-5 were as described below.
Molecular weight of side chain: approximately 600 on average.
Weight-average molecular weight Mw (GPC) of polyrotaxane monomer: 880,000.
Ratio of modification with acrylate group (ratio of acrylate group introduced into the end OH group of side chain): 85 mol %.
Ratio of remaining end OH group in side chain: 15 mol %.
Water content: 400 ppm.
Clathrating number of cyclic molecules: 0.25.

This polyrotaxane monomer (A) has an adamantyl group at both ends of the axial molecule and has an acrylate group and a hydroxy group at the end of each side chain.

The proton nuclear magnetic resonance spectrum of the polyrotaxane monomer (A) (RX-5) was measured with a ¹H-NMR measuring instrument (JNM-LA500 from JEOL Ltd.) and the following characteristic peaks were observed: a peak derived from a methylene group neighboring to the carbonyl carbon in the polycaprolactone structure at around δ2.3 ppm, a peak derived from a methylene group neighboring to the nitrogen atom of the urethane group and a peak derived from a methylene group neighboring to the oxygen atom in the polycaprolactone structure at around δ3.5 ppm, a peak derived from a methylene group neighboring to the oxygen atom of the polycaprolactone structure at around δ4.0 ppm, a peak derived from a methylene group bonding to the acryloyl group at around δ4.2 ppm, and three peaks derived from an acryloyl group at around δ5.8 to 6.5 ppm. The results are summarized in Table 1.

### <Comparative Example 1>

This is a polyrotaxane monomer (RX) not processed in the water content-reducing step (1-5) in Example 1. The physical properties of the polyrotaxane monomer; RX are as described below.
Weight-average molecular weight Mw (GPC) of polyrotaxane: 200,000.
Degree of side-chain modification: 0.5 (by percentage, 50%).
Molecular weight of side chain: approximately 350 on average.
Water content: 10,000 ppm.
Clathrating number of cyclic molecules: 0.25.

This polyrotaxane monomer has an adamantyl group at both ends of the axial molecule and has a hydroxy group at the end of each side chain. The results are summarized in Table 1.

### <Comparative Example 2>

This is a polyrotaxane monomer not processed in the water content-reducing step in Example 4. Except the point, this was produced according to the same method as in Example 4. The physical properties of the polyrotaxane monomer (RX-6) are as described below.
Weight-average molecular weight Mw (GPC) of polyrotaxane: 700,000.
Degree of side-chain modification: 0.5 (by percentage, 50%).
Molecular weight of side chain: approximately 500 on average.
Water content: 12,000 ppm.
Clathrating number of cyclic molecules: 0.25.

This polyrotaxane monomer has an adamantyl group at both ends of the axial molecule and has a hydroxy group at the end of each side chain. The results are summarized in Table 1.

### <Comparative Example 3>

In Example 5, the polycaprolactone-modified polyrotaxane (RX-6) prepared in the above Comparative Example 2 was used in place of RX-4. According to the same method as in Example 5 except this point, a polyrotaxane monomer (RX-7) having an acrylate group introduced into the side chain as a radical polymerizable group was produced.

The physical properties of the polyrotaxane monomer (RX-7) are as described below.
Molecular weight of side chain: approximately 600 on average.
Weight-average molecular weight Mw (GPC) of polyrotaxane monomer: 880,000.
Ratio of modification with acrylate group (ratio of acrylate group introduced into the end OH group of side chain): 85 mol%.
Ratio of remaining end OH group in side chain: 15 mol %.
Water content: 9900 ppm.
Clathrating number of cyclic molecules: 0.25.

This polyrotaxane monomer has an adamantyl group at both ends of the axial molecule and has an acrylate group and a hydroxy group at the end of each side chain. The results are summarized in Table 1.

**Table 1**

| No. | Component A | Water content (ppm) | Molecular Weight of Side Chain (Mn) | Molecular Weight (Mw) | Molar Ratio of Polymerizable Groups | |
|---|---|---|---|---|---|---|
| | | | | | End OH Group in Side Chain | End Acrylic Group in Side Chain |
| Example 1 | RX-1 | 500 | 350 | 200000 | 100% | 0% |
| Example 2 | RX-2 | 3000 | 350 | 200000 | 100% | 0% |
| Example 3 | RX-3 | 5000 | 350 | 200000 | 100% | 0% |
| Example 4 | RX-4 | 800 | 500 | 700000 | 100% | 0% |
| Example 5 | RX-5 | 400 | 600 | 880000 | 15% | 85% |
| Comparative Example 1 | RX | 10000 | 350 | 200000 | 100% | 0% |
| Comparative Example 2 | RX-6 | 12000 | 500 | 700000 | 100% | 0% |
| Comparative Example 3 | RX-7 | 9900 | 600 | 880000 | 15% | 85% |

Polymerizable Monomer (B);
Iso(thio) cyanate compound (B1)
IPDI: Isophorone diisocyanate
XDI: M-xylylene diisocyanate

### Urethane Prepolymer (B12)

Pre-1: Isocyanate-terminated urethane prepolymer having iso(thio)cyanate equivalent of 905.

### Production Method for Pre-1

In a flask equipped with a nitrogen inlet tube, a thermometer and a stirrer in a nitrogen atmosphere, 50 g of 2,4-tolylene diisocyanate, 90 g of polyoxytetramethylene glycol (number-average molecular weight: 1000) and 12 g of diethylene glycol were reacted at 80°C for 6 hours to give an isocyanate-terminated urethane prepolymer having an iso(thio)cyanate equivalent of 905 (Pre-1).

### (Thi)ol Compound (B3)

PL1: Duranol from Asahi Kasei Chemicals Corporation (polycarbonate diol, number-average molecular weight 500).
PL2: Duranol from Asahi Kasei Chemicals Corporation (polycarbonate diol, number-average molecular weight 800).
TMP: Trimethylolpropane.
PEMP: Pentaerythritol tetrakis(3-mercaptopropionate).
PELE23: Polyoxyethylene lauryl ether (n is approximately 23).

### Amino Group-Containing Monomer (B4)

MOCA: 4,4'-Methylenebis(o-chloroaniline).
IPDA: Isophoronediamine.

Radical Polymerizable Monomer (B5)
Component (B511)
TMPT: Trimethylolpropane trimethacrylate.
Component (B512)
3PG: Tripropylene glycol dimethacrylate.
Component (B516)
9G: Polyethylene glycol dimethacrylate (average chain length of ethylene glycol chain 9, average molecular weight 536).
14G Polyethylene glycol dimethacrylate (average chain length of ethylene glycol chain 14, average molecular weight 736).
EB4858: Difunctional urethane methacrylate from Daicel UCB Corporation (acryl equivalent 227).
Component (B52)
αMS: α-methylstyrene.
MSD: α-methylstyrene dimer.
Component (B54)
GMA: Glycidyl methacrylate.
MOPMS: γ-methacryloyloxypropyltrimethoxysilane.
Polymerization Curing Accelerator (C)
Urethane or Urea Reaction Catalyst (C1)
DBTD: Dibutyltin dilaurate
Radical Polymerization Initiator (C5)

### <Thermal Polymerization Initiator>

Perbutyl ND: t-butylperoxy neodecanoate (trade name: Perbutyl ND, from NOF Corporation).
Perocta O: 1,1,3,3-tetramethylbutyl peroxy-2-ethylhexanoate (trade name: Perocta O, from NOF Corporation).

### <Photopolymerization Initiator>

PI: Phenylbis(2,4,6-trimethylbenzoyl)phosphine oxide (trade name, Irgacure 819, from BASF AG).

### Photochromic Compound (D)

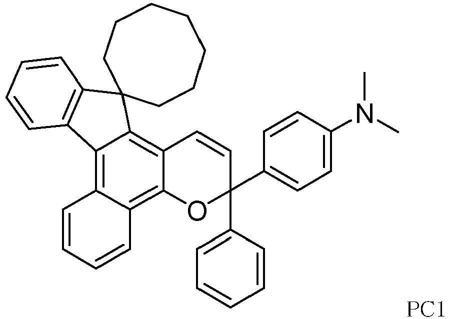

### (Others)

### <Release Agent>

DBP: Di-n-butyl tin.

### <Solvent>

DMF: Dimethylsulfoxide.

IPA: Isopropyl alcohol.

### <Stabilizer>

HALS: Bis(1,2,2,6,6-pentamethyl-4-piperidyl) sebacate (molecular weight 508).

### <Leveling Agent>

L1: Trade name, L7001, from DuPont Toray Specialty Material Corporation.

### <Hollow Particles>

920-40: Microcapsule 920-40 having density of 0.03 g/cm³ (from Japan Fillite Co.,

Ltd.), hollow particles having a shell of a copolymer of acrylic monomer and vinylidene chloride.

Hollow particles 2: Urethane resin microcapsules having density of 0.13 g/cm³.

Hollow particles 2 are microcapsules having a shall of an urethane-based resin.

### <Production Method for Hollow Particles 2/Production Method for Urethane Resin Microballoons>

200 g of a solution of a polyacrylic acid having a molecular weight of approximately 150,000, having a solid content of about 25% (from FUJIFILM Wako Pure Chemical Corporation), and 50 g a sodium polyacrylate having a polymerization degree of 22,000 to 70,000 (from FUJIFILM Wako Pure Chemical Corporation) were added to 1900 g of pure water, and dissolved therein by heating to prepare an aqueous solution of polyacrylic acid/sodium polyacrylate. 120 g of toluene was added to 1000 g of the aqueous solution of polyacrylic acid/sodium polyacrylate, and then emulsified with a homomixer at 3000 rpm for 10 minutes. Subsequently, while this was again stirred at 3000 rpm, 10.5 g of a water-dispersible isocyanate, Takenate WD-730 (from Mitsui Chemical Corporation) was added thereto, and further mixed for 10 minutes. Subsequently, the resultant dispersion was polymerized at 80°C for 4 hours. The formed fine particles were taken out through filtration, and vacuum-dried to give microballoons (hollow particles 2). The resultant microballoons were urethane resin-formed microballoons having a grain size of 50 pm and a density of 0.15 g/cm³.

### Example 6

Using the polyrotaxane monomer, a photochromic curable composition was prepared according to the following formulation. The components were mixed to give a uniform liquid (photochromic curable composition). The blending amounts are shown in Table 1.

Formulation:

| | |
|---|---|
| Polyrotaxane Monomer (A): RX-1 | 10 parts by mass |
| Iso(thio)cyanate Compound (B1): XDI | 40 parts by mass |
| (Thi)ol Compound (B3): PEMP | 50 parts by mass |
| Urethane or Urea Reaction Catalyst (C1): DBTD | 0.1 parts by mass |
| Photochromic Compound (D): PC1 | 0.04 parts by mass |
| (Other) Internal Release Agent, DBP: | 0.1 parts by mass |

Using the above-mentioned photochromic curable composition, a photochromic cured product was produced according to a kneading method. The water content in the polymerizable monomer (B) (total amount in XDI and PEMP) was 1500 ppm or less. The polymerization method is described below. Specifically, the uniform liquid was fully defoamed, and then cast into a molding mold formed of a lubricated and curved glass mold and a casting mold formed of a gasket of an ethylene-vinyl acetate copolymer. Next, the glass mold in which the monomer had been cast was set in an oven in such a manner that the convex surface thereof could face downward, then gradually heated therein from 30°C up to 95°C and thus cured for 15 hours. After polymerization, the photochromic cured product was taken out of the glass mold of the molding mold. According to this operation, 50 sheets of the photochromic cured product were prepared. The blending ratio of the constituent components is summarized in Table 2.

The appearance evaluation of the resultant photochromic cured product was 1, and the L-scale Rockwell hardness (HL) thereof was 95. Regarding the photochromic characteristics of the resultant photochromic cured product, the maximum absorption wavelength was 594 nm, the coloration density was 0.62, and the decoloring speed was 75 seconds. The appearance evaluation (moldability), the L-scale Rockwell hardness, the maximum absorption wavelength, the coloration density and the decoloring speed were evaluated as follows. The evaluation results are summarized in Table 3.

### [Evaluation Items]

(1) Appearance evaluation: The number of defective sheets with foams appearing at the edge of 50 sheets of the molded photochromic cured product (80 mmφ) was counted for appearance evaluation.
   1: 0 of 50 sheets.
   2: 1 to 2 of 50 sheets.
   3: 3 to 4 of 50 sheets.
   4: 5 to 10 of 50 sheets.
(2) L-scale Rockwell hardness (HL): The cured product was stored in a room at 25°C for 1 day, and using an Akashi Rockwell hardness tester (Type: AR-10), the L-scale Rockwell hardness of the photochromic cured product was measured. An average value is shown in the Table.
(3) Maximum absorption wavelength (λmas): This is a maximum absorption wavelength after coloration, measured using a spectrophotometer (instantaneous multichannel photodetector MCPD 1000) from Otsuka Electronics Co., Ltd. The maximum absorption wavelength relates to the color tone in coloration. An average value is shown in the Table.
(4) Coloration density {ε(120) - ε(0)}: This is a difference between the absorbance after photoirradiation for 120 seconds {ε(120)} and the absorbance before photoirradiation {ε(0)} at the maximum absorption wavelength. A higher value of the difference means more excellent photochromic performance. In addition, the product was colored outdoor, and the color tone was evaluated visually. An average value is shown in the Table.
(5) Decoloring speed [t_{1/2} (sec)]: This is a time taken until the absorbance at the maximum absorption wavelength of the sample decreased to 1/2 of {ε(120) - ε(0)} after photoirradiation for 120 seconds and thereafter stopping the photoirradiation. A shorter period of time means more excellent photochromic performance. An average value is shown in the Table.

### <Example 7, Example 8, Comparative Example 4>

According to the same method as in Example 6 except that the photochromic curable composition as shown in Table 2 was used, photochromic cured products were produced and evaluated. The blending ratio of the constituent components is summarized in Table 2. The evaluation results are shown in Table 3. In Example 7, Example 8 and Comparative Example 4, the water content in the polymerizable monomer (B) was 1500 ppm or less.

As obvious from Examples 6 to 8 and Comparative Example 4, it is known that the cured products produced by polymerizing the photochromic curable composition using the polyrotaxane monomer of the present invention can achieve productivity increase while exhibiting excellent photochromic characteristics.

**Table 2**

| | Molding Method | Component (A) (part by mass) | Component (B1) (part by mass) | Component (B3) (part by mass) | Component (C) (part by mass) | Component (D) (part by mass) | Other (part by mass) |
|---|---|---|---|---|---|---|---|
| Example 6 | Kneading Method | RX-1(10) | XDI(40) | PEMP(50) | DBTD(0.1) | PC1(0.04) | DBP(0.1) |
| Example 7 | Kneading Method | RX-2(10) | XDI(40) | PEMP(50) | DBTD(0.1) | PC1(0.04) | DBP(0.1) |
| Example 8 | Kneading Method | RX-3(10) | XDI(40) | PEMP(50) | DBTD(0.1) | PC1(0.04) | DBP(0.1) |
| Comparative Example 4 | Kneading Method | RX(10) | XDI(40) | PEMP(50) | DBTD(0.1) | PC1(0.04) | DBP(0.1) |

**Table 3**

| | Appearance | HL | Maximum Absorption Wavelength (λmax) | Coloration Density | Decoloring Speed (sec) |
|---|---|---|---|---|---|
| Example 6 | 1 | 95 | 594 | 0.62 | 75 |
| Example 7 | 2 | 95 | 594 | 0.62 | 75 |
| Example 8 | 3 | 96 | 594 | 0.61 | 76 |
| Comparative Example 4 | 4 | 97 | 594 | 0.59 | 78 |

### Example 9

Using the above-mentioned polyrotaxane monomer, a photochromic curable composition was prepared according to the following formulation. The components were mixed to prepare a uniform liquid (photochromic curable composition). The blending amount is shown in Table 4.

Formulation;

| | | |
|---|---|---|
| Polyrotaxane (A): RX-4 | | 5 parts by mass |
| Iso(thio)cyanate compound (B1): IPDI | | 49 parts by mass |
| (Thi)ol compounds (B3): PL1 | | 21 parts by mass |
| | TMP | 17 parts by mass |
| | PELE23 | 8 parts by mass |
| Urethane or urea reaction catalyst (C1): DBTD | | 0.1 parts by mass |
| Photochromic compound (D): PC1 | | 4 parts by mass |

Using the photochromic curable composition, a photochromic laminate was produced according to a coating method. The water content in the polymerizable monomer (B) was 1500 ppm or less.

As an optical substrate, a thiourethane-based plastic lens having a center thickness of approximately 2 mm, a spherical diopter power of -6.00 D and a refractive index of 1.60 was prepared. The thiourethane-based plastic lens was previously alkali-etched with an aqueous 10% sodium hydroxide solution, at 50°C for 5 minutes, and then fully washed with distilled water.

Using a spin coater (1H-DX2, from MIKASA Co., Ltd.), the photochromic curable composition was dropwise applied onto the surface of the plastic lens kept rotated at 2000 rpm. Subsequently, this was polymerized and cured by heating at 120°C for 3 hours, thereby giving a photochromic laminate composed of a photochromic cured product laminated on the surface of the plastic lens. The film thickness of the photochromic cured product (photochromic layer) was approximately 30 pm. According to this method, 50 sheets of the photochromic laminate were produced.

The appearance evaluation of the resultant photochromic laminate was 1, and the Vickers hardness thereof was 13 (average value). Regarding the photochromic characteristics (as average values) of the laminate, the maximum absorption wavelength was 595 nm, the coloration density was 0.85, and the decoloring speed was 50 seconds. The appearance evaluation and the Vickers hardness were evaluated and measured according to the methods mentioned below, and the photochromic characteristics were evaluated according to the methods described in Example 6. The evaluation results are shown in Table 5.

### [Evaluation Items]

(6) Appearance evaluation: The number of defective sheets with foams of 50 sheets of the molded photochromic cured product (80 mmϕ) was counted for appearance evaluation.
1: 0 of 50 sheets.
2: 1 to 2 of 50 sheets.
3: 3 to 4 of 50 sheets.
4: 5 to 10 of 50 sheets.

(7) Vickers hardness: The Vickers hardness of the resultant photochromic cured product (photochromic layer) was measured using a Micro Vickers Hardness Tester PMT-X7A (from Matsuzawa Co., Ltd.). As the indenter, a four-sided pyramid diamond indenter was used, and the test was carried out under a load of 10 gf, and for an indenter retention time of 30 seconds. The measurement test was repeated four times (four passes), and the data of three passes excluding the first pass having a large measurement error were averaged to give an average value. The average value is shown in the Table.

### <Comparative Example 5>

A photochromic laminate was produced according to the same method as in Example 9 except that the photochromic curable composition shown in Table 4 was used, and evaluated. The blending ratio of the constituent components is summarized in Table 4. The evaluation results are shown in Table 5. The water content in the polymerizable monomer (B) was 1500 ppm or less.

As obvious from Example 9 and Comparative Example 5, the cured products produced by polymerizing the photochromic curable composition using the polyrotaxane monomer of the present invention make it possible to increase the productivity while exhibiting excellent photochromic characteristics.

**Table 4**

| | Molding Method | Component (A) (part by mass) | Component (B1) (part by mass) | Component (B3) (part by mass) | Component (C) (part by mass) | Component (D) (part by mass) |
|---|---|---|---|---|---|---|
| Example 9 | Lamination Method | RX-4(5) | IPDI(49) | PL1(21)/ TMP(17)/ PELE23(8) | DBTD(0.1) | PC1(4) |
| Comparative Example 5 | Lamination Method | RX-6(5) | IPDI(49) | PL1(21)/ TMP(17)/ PELE23(8) | DBTD(0.1) | PC1(4) |

**Table 5**

| No. | Appearance Evaluation | Vickers Hardness | Maximum Absorption Wavelength (λmax) | Coloration Density | Decoloring Speed (sec) |
|---|---|---|---|---|---|
| Example 9 | 1 | 13 | 595 | 0.85 | 50 |
| Comparative Example 5 | 4 | 13 | 595 | 0.84 | 48 |

### <Example 10>

Using the above-mentioned polyrotaxane monomer, a photochromic curable composition was prepared according to the following formulation. The components were fed into a reactor, and reacted at 120°C for 5 hours in a nitrogen atmosphere.

Formulation;

| | |
|---|---|
| Iso(thio)cyanate compound (B1): IPDI | 24 parts by mass |
| (Thi)ol compound (B3): PL2 | 61 parts by mass |
| (Other) Solvent: DMF | 300 parts by mass |

Afterwards, the reaction product was cooled down to 25°C, and a chain extender of:

| | |
|---|---|
| Component (B4): IPDA | 4 parts by mass |
| was dropwise added thereto, and reacted at 25°C for 1 hour. Subsequently, further: | |
| Polyrotaxane monomer (A): RX-1 | 11 parts by mass |

was added, and reacted at 100°C to give a polyurethane-urea resin (U1).

Components of the following formulation were added to the resultant

| | |
|---|---|
| polyurethane-urea resin (U1). | |
| Photochromic compound (D): PC1 | 0.3 parts by mass |
| (Other) Solvent: isopropyl alcohol | 400 parts by mass |
| (Other) Stabilizer: HALS | 0.5 parts by mass |

After the addition, these were dissolved ultrasonically while stirred at 80°C to give a photochromic curable composition. The formulation of the photochromic curable composition is shown in Table 6. The water content in the polymerizable monomer (B) was 1500 ppm or less.

Using the photochromic curable composition, a photochromic laminate sheet was produced according to a binder method. Specifically, the photochromic curable composition was applied to a fluororesin sheet having a flat and smooth surface, and dried at 80°C for 1 hour, and the resultant photochromic sheet formed of the photochromic cured product having a thickness of 30 pm was sandwiched between two polycarbonate sheets each having a thickness of 400 pm to give a photochromic laminate sheet. The resultant photochromic laminate sheet was given a score 1 in sheet formability evaluation, and had a maximum absorption wavelength of 590 nm, a coloration density of 0.96 and a decoloring speed of 49 seconds. The sheet formability was evaluated according to the following evaluation method. The photochromic characteristics were evaluated in the same manner as in Example 5. The results are shown in Table 7.

### [Evaluation Item]

(8) Sheet formability evaluation: Presence or absence of foams in the resultant 50 photochromic laminate sheets (50 mm × 50 mm) was checked.
1: 0 of 50 sheets.
2: 1 to 2 of 50 sheets.
3: 3 to 4 of 50 sheets.
4: 5 to 10 of 50 sheets.

### <Comparative Example 6>

A photochromic laminate sheet was produced according to the same method as in Example 10 except that the photochromic curable composition having a formulation shown in Table 6 was used, and evaluated. The blending ratio of the constituent components is summarized in Table 6. The results are shown in Table 7. The water content in the polymerizable monomer (B) was 1500 ppm or less.

As obvious from Example 10 and Comparative Example 6, the cured products produced by polymerizing the photochromic curable composition using the polyrotaxane monomer of the present invention make it possible to increase the productivity while exhibiting excellent photochromic characteristics.

**Table 6**

| No. | Molding Method | Component (A) (part by mass) | Component (B1) (part by mass) | Component (B3) (part by mass) | Component (B4) (part by mass) | Component (D) (part by mass) | Additives (part by mass) |
|---|---|---|---|---|---|---|---|
| Example 10 | binder method | RX-1(11) | IPDI(24) | PL2(61) | IPDA(4) | PC1(0.3) | DMF(300) HALS(0.5)/ IPA(400) |
| Comparative Example 6 | binder method | RX(11) | IPDI(24) | PL2(61) | IPDA(4) | PC1(0.3) | DMF(300) HALS(0.5)/ IPA(400) |

**Table 7**

| No. | Sheet Formability | Maximum Absorption Wavelength (λmax) | Coloration Density | Decoloring Speed (sec) |
|---|---|---|---|---|
| Example 10 | 1 | 590 | 0.96 | 49 |
| Comparative Example 6 | 4 | 590 | 0.95 | 47 |

### <Example 11>

According to the following formulation, the components were fully mixed to prepare a photochromic curable composition.

Formulation;

| | | |
|---|---|---|
| Polyrotaxane monomer (A): RX-5 | | 15 parts by mass |
| Radical polymerizable monomer (B511): TMPT | | 13 parts by mass |
| Radical polymerizable monomer (B512): 3PG | | 45 parts by mass |
| Radical Polymerizable monomer (B516): EB4858 | | 24 parts by mass |
| Radical polymerizable monomer (B52): αMS | | 0.5 parts by mass |
| | MSD | 1.5 parts by mass |
| Radical polymerizable monomer (B54): | GMA | 1 part by mass |
| Photochromic compound (D): PC1 | | 0.04 parts by mass |
| (Other) Stabilizer: HALS | | 0.1 parts by mass |

The above formulation (formulation of photochromic curable composition) is shown in Table 8.

The resultant mixed liquid (photochromic curable composition) was subjected to a storage stability test at 30°C for 6 months under a light-shielded condition. A polymerization initiator was added to the mixed liquid after storage, according to the following formulation. The blending ratio of the components is shown in Table 8. The water content in the polymerizable monomer (B) was 1500 ppm or less.

Formulation;

| | | |
|---|---|---|
| Radical polymerization initiator (C5) | : Perbutyl ND | 1.5 parts by mass |
| | : Perocta O | 0.1 parts by mass |

The resultant mixed liquid (polymerization initiator-added photochromic curable composition) was cast into a casting mold formed of a glass plate and a gasket formed of an ethylene-vinyl acetate copolymer, and cast into a molding mold composed of a curved glass mold and a casting mold formed of a gasket of an ethylene-vinyl acetate copolymer. Next, the monomer-cast glass mold was so set in an oven that the convex surface thereof could face downward, and then cured under heat by gradually heating from 30°C to 90°C taking 18 hours. After polymerization, the photochromic cured product (lens) was taken out of the glass mold of the casting mold.

Apart from the photochromic cured product produced according to the above-mentioned method, the same photochromic curable composition as above was separately prepared, then a polymerization initiator was immediately added thereto without storing the composition to produce a photochromic cured product (lens) to be a comparative subject.

These lenses (the lens produced after the storage stability test, and the lens produced not subjected to the storage stability test) were tested and analyzed in the same manner as in Example 6 to evaluate the appearance, the L-scale Rockwell hardness, and the photochromic characteristics. The results are shown in Table 9.

The photochromic cured product produced from the photochromic curable composition subjected to the storage stability test was given a score of appearance of 1, and had an L-scale Rockwell hardness (HL) of 70. Regarding the photochromic characteristics of the photochromic cured product, the maximum absorption wavelength thereof was 588 nm, the coloration density was 0.95 and the decoloring speed was 50 seconds. These data were the same as those of the photochromic cured product produced from the photochromic curable composition not subjected to the storage stability test.

### <Comparative Example 7>

A photochromic cured product was produced according to the same method as in Example 11 except that a photochromic curable composition having the formulation shown in Table 8 was used, and evaluated. The blending ratio of the components is summarized in Table 8. The results are shown in Table 9. The water content in the polymerizable monomer (B) was 1500 ppm or less.

As obvious from Example 11 and Comparative Example 7, the photochromic composition produced using the polyrotaxane monomer of the present invention exhibits excellent storage stability while exhibiting excellent photochromic characteristics.

**Table 8**

| No. | Molding Method | Component (A) (part by mass) | Component (B511) (part by mass) | Component (B512) (part by mass) | Component (B516) (part by mass) | Component (B52) (part by mass) | Component (B54) (part by mass) | Component (C) (part by mass) | Component (D) (part by mass) | Additive (part by mass) |
|---|---|---|---|---|---|---|---|---|---|---|
| Example 11 | kneading method | RX-5 (15) | TMPT (13) | 3PG (45) | EB4858 (24) | αMS(0.5)/ MSD(1.5) | GMA (1) | Perbutyl ND (1.5) Perocta O (0.1) | PC1 (0.04) | HALS (0.1) |
| Comparative Example 7 | kneading method | RX-7 (15) | TMPT (13) | 3PG (45) | EB4858 (24) | αMS(0.5)/ MSD(1.5) | GMA (1) | Perbutyl ND (1.5) Perocta O (0.1) | PC1 (0.04) | HALS (0.1) |

**Table 9**

| No. | Appearance | | HL | | Maximum Absorption Wavelength (λmax) | | Coloration Density | | Decoloring Speed (sec) | |
|---|---|---|---|---|---|---|---|---|---|---|
| | no storage | stored for 6 months | no storage | stored for 6 months | no storage | stored for 6 months | no storage | stored for 6 months | no storage | stored for 6 months |
| Example 11 | 1 | 1 | 70 | 70 | 588 | 588 | 0.95 | 0.95 | 50 | 50 |
| Comparative Example 7 | 1 | 1 | 70 | 65 | 588 | 588 | 0.95 | 0.86 | 50 | 53 |

### <Example 12>

According to the following formulation, the components were fully mixed to prepare a photochromic curable composition.

Formulation;

| | | |
|---|---|---|
| Polyrotaxane monomer (A): RX-5 | | 10 parts by mass |
| Radical polymerizable monomer (B511): TMPT | | 40 parts by mass |
| Radical polymerizable monomer (B516) | : 14G | 40 parts by mass |
| | : 9G | 7 parts by mass |
| Radical polymerizable monomer (B54): GMA | | 1 part by mass |
| Radical polymerization initiator (C5): PI | | 0.3 parts by mass |
| Photochromic compound (D): PC1 | | 3 parts by mass |
| (Other) Stabilizer: HALS | | 3 parts by mass |

The resultant mixed liquid (photochromic composition) was subjected to a storage stability test at 30°C for 6 months under a light-shielded condition. A leveling agent and a radical polymerizable monomer were added to the mixed liquid after storage according to the following formulation, and uniformly stirred and defoamed to give a photochromic curable composition. The blending ratio of the components is shown in Table 10. The water content in the polymerizable monomer (B) was 1500 ppm or less.
Formulation;

| | |
|---|---|
| (Other) Leveling agent: L7001 | 0.1 parts by mass |
| Radical polymerizable monomer (B54): MOPMS | 2 parts by mass |

Using the photochromic curable composition, a photochromic laminate was produced according to the following method.

As an optical substrate, a thiourethane-based plastic lens having a center thickness of approximately 2 mm, a spherical diopter power of -6.00 D and a refractive index of 1.60 was prepared. The thiourethane-based plastic lens was previously alkali-etched with an aqueous 10% sodium hydroxide solution, at 50°C for 5 minutes, and then fully washed with distilled water.

Using a spin coater (1H-DX2, from MIKASA Co., Ltd.), the photochromic curable composition was dropwise applied onto the surface of the plastic lens kept rotated at 2000 rpm. The lens coated with the photochromic curable composition was photoirradiated with a metal halide lamp at a power of 200 mW/cm² in a nitrogen gas atmosphere for 90 seconds to cure the coating film. Subsequently, this was further heated at 110°C for 1 hour to produce a photochromic layer-having photochromic laminate (lens). The film thickness of the photochromic layer was about 30 µm.

Apart from the above photochromic laminate, the same photochromic composition as above was separately prepared, then a leveling agent was immediately added thereto without storing the composition to produce a photochromic laminate (lens) to be a comparative subject.

These lenses (the lens produced after the storage stability test, and the lens produced not subjected to the storage stability test) were tested and analyzed in the same manner as in Example 9 to evaluate the appearance, the Vickers hardness, and the photochromic characteristics. The results are shown in Table 11.

The photochromic laminate produced using the photochromic coating composition that had been subjected to the storage stability test was given a score of appearance of 1, and had a Vickers hardness of 5.5. Regarding the photochromic characteristics of the photochromic laminate, the maximum absorption wavelength thereof was 590 nm, the coloration density was 0.97 and the decoloring speed was 50 seconds. These data were the same as those of the photochromic laminate (lens) produced from the photochromic curable composition not subjected to the storage stability test.

### <Comparative Example 8>

A photochromic cured product was produced according to the same method as in Example 12 except that a photochromic curable composition having the formulation shown in Table 10 was used, and evaluated. The blending ratio of the components is summarized in Table 10. The results are shown in Table 11. The water content in the polymerizable monomer (B) was 1500 ppm or less.

As obvious from Example 12 and Comparative Example 8, the photochromic curable composition produced using the polyrotaxane monomer of the present invention exhibits excellent storage stability while exhibiting excellent photochromic characteristics.

**Table 10**

| | Molding Method | Component (A) (part by mass) | Component (B511) (part by mass) | Component (B516) (part by mass) | Component (B54) (part by mass) | Component (C) (part by mass) | Component (D) (part by mass) | Additive (part by mass) |
|---|---|---|---|---|---|---|---|---|
| Example 12 | surface method | RX-5 (10) | TMPT (40) | 14G(40)/ 9G(7) | GMA(1)/ MOPMS(2) | PI (0.3) | PC1 (3) | HALS(3) /L1(0.1) |
| Comparative Example 8 | surface method | RX-7 (10) | TMPT (40) | 14G(40)/ 9G(7) | GMA(1)/ MOPMS(2) | PI (0.3) | PC1 (3) | HALS(3) /L1(0.1) |

**Table 11**

| No. | Appearance | | Vickers Hardness | | Maximum Absorption Wavelength (λmax) | | Coloration Density | | Decoloring Speed (sec) | |
|---|---|---|---|---|---|---|---|---|---|---|
| | no storage | after stored for 6 months | no storage | after stored for 6 months | no storage | after stored for 6 months | no storage | after stored for 6 months | no storage | after stored for 6 months |
| Example 12 | 1 | 1 | 5.5 | 5.5 | 590 | 590 | 0.97 | 0.97 | 50 | 50 |
| Comparative Example 8 | 1 | 1 | 5.5 | 5 | 590 | 590 | 0.97 | 0.84 | 50 | 52 |

### Example 13

Using a polyrotaxane monomer, a polishing pad composition was prepared according to the following formulation.

The component (A) RX-1 (24 parts by mass) and the component (B4) MOCA (5 parts by mass) were mixed at 120°C to prepare a uniform solution, then fully degassed and cooled down to 100°C (solution 1). Separately, the other component 920-40 (0.8 parts by mass) was added to the component (B12) Pre-1 (71 parts by mass) that had been heated at 70°C, and stirred with a planetary centrifugal mixer to prepare a uniform solution (solution 2). The solution 1 was added to the solution 2 and uniformly mixed to give a curable composition, and the curable composition was cast into a mold, and cured at 100°C for 15 hours. After polymerization, the urethane resin was taken out of the casting mold, and sliced to give a polishing pad of urethane resin having a thickness of 2 mm or a thickness of 1 mm.

The blending amount of each component is shown in Table 12. The water content in the polymerizable monomer (B) was 1500 ppm or less.

| | |
|---|---|
| Polyrotaxane monomer (A): RX-1 | 24 parts by mass |
| Urethane prepolymer (B12): Pre-1 | 71 parts by mass |
| Amine monomer (B4): MOCA | 5 parts by mass |
| (Other) Hollow particles: 920-40 | 0.8 parts by mass |

Regarding the characteristics of the polishing pad of urethane resin produced in the above, the foam appearance evaluation score thereof was 1, the polishing rate was 3.0 µm/hr, the scratch resistance score was 1, the edge sagging score was 1, the Taber wear volume was 20 mg, the hardness was 21 as D hardness, the density was 0.8 g/cm³, and the hysteresis loss was 25%. The evaluation methods are described below.

### [Evaluation Item]

### (9) Foam Appearance Evaluation (for foam type)

50 sheets of the produced polishing pad (10 mm × 10 mm) was checked for the surface appearance (one surface), and the number of the sheets having foams of larger than 300 pm was counted for foam appearance evaluation.
1: 0 of 50 sheets.
2: 1 to 2 of 50 sheets.
3: 3 to 4 of 50 sheets.
4: 5 to 10 of 50 sheets.

(10) Polishing Rate: The polishing condition is shown below. 30 wafers were tested.
Polishing pad: having spiral grooves formed on the surface thereof and having a size of 380 mmϕ and a thickness of 1 mm.
Substance to be polished: 2-inch sapphire wafer.
Slurry: FUJIMI COMPOL 80 undiluted solution.
Pressure: 411 g/cm².
Rotation number: 60 rpm.
Time: 1 hour

Under the above condition, the wafers were polished and the polishing rate was measured. The polishing rate is an average value of the data of the 50 wafers.

(11) Scratch Resistance: Presence or absence of scratches in 50 wafers polished under the condition of the above (10) was checked. The wafers were evaluated under the following criteria.
1: None of 50 wafers scratched.
2: 1 to 2 of 50 wafers scratched.
3: 3 to 4 of 50 wafers scratched.
4: 5 to 10 of 50 wafers scratched.

(12) Wafer Edge Sagging: Edge sagging of wafers polished under the condition of the above (10) was checked with a laser microscope.
1: Edge sagging ran 0 to 400 pm.
2: Edge sagging ran more than 400 pm and 800 pm or less.
3: Edge sagging ran more than 800 pm.

The evaluation was performed on an average value.

(13) Taber wear volume: The Taber wear volume of the polishing pad of urethane resin was measured using Taber Model 5130. In the Taber wear test, the load was 1 kg, the rotation speed was 60 rpm, the rotation number was 1000 rotations, and the wear ring was H-18. The evaluation was performed on an average value.

(14) According to JIS (hardness test) K6253, the Shore A hardness and the Shore D hardness were measured using a durometer from Kobunshi Keiki Co., Ltd. Those having a relatively low hardness were measured as a Shore A hardness, and those having a relatively high hardness were measured as a Shore D hardness. The evaluation was performed on an average value.

(15) Density: The density was measured with (DSG-1) from Toyo Seiki Seisakusho, Ltd. The evaluation was performed on an average value.

(16) Hysteresis Loss: The resin was stamped out to have a dumbbell No. 8 shape having a thickness of 2 mm, then elongated by 20 mm at 10 mm/min, using an autograph AG-SX from Shimadzu Corporation, and restored to have a zero stress, and the hysteresis loss at that time was measured. The evaluation was performed on an average value.

The above evaluation results are shown in Table 13.

### Examples 14 to 16, Comparative Example 9

Polishing pad of urethane resin were produced according to the same method as in Example 13 except that the curable composition having the formulation shown in Table 12 was used, and evaluated. The blending ratio of the components is summarized in Table 12. The results are shown in Table 13. In Examples 14 to 16, and Comparative Example 9, the water content in the polymerizable monomer (B) was 1500 ppm or less.

As obvious from Examples 13 to 16 and Comparative Example 9, the polishing pads produced by curing a polishing pad composition (curable composition) prepared using a polyrotaxane monomer of the present invention exhibit excellent appearance, and excellent polishing pad characteristics.

**Table 12**

| | Molding Method | Component (A) (part by mass) | Component (B) (part by mass) | Other (part by mass) |
|---|---|---|---|---|
| Example 13 | polishing pad | RX-1(24) | Pre-1(71)/MOCA(5) | 920-40(0.8) |
| Example 14 | polishing pad | RX-2(24) | Pre-1(71)/MOCA(5) | 920-40(0.8) |
| Example 15 | polishing pad | RX-3(24) | Pre-1(71)/MOCA(5) | 920-40(0.8) |
| Comparative Example 9 | polishing pad | RX(24) | Pre-1(71)/MOCA(5) | 920-40(0.8) |
| Example 16 | polishing pad | RX-1(24) | Pre-1(71)/MOCA(5) | hollow particles 2 (0.32) |

**Table 13**

| No. | Appearance | Polishing Rate µm/hr | Scratch Resistance | Edge Sagging | Taber Wear Volume (mg) | D Hardness | Density (g/cm³) | Hysteresis Loss (%) |
|---|---|---|---|---|---|---|---|---|
| Example 13 | 1 | 3.0 | 1 | 1 | 20 | 21 | 0.8 | 25 |
| Example 14 | 2 | 3.0 | 1 | 1 | 20 | 21 | 0.8 | 25 |
| Example 15 | 3 | 3.0 | 2 | 2 | 20 | 21 | 0.79 | 25 |
| Comparative Example 9 | 4 | 3.0 | 4 | 3 | 22 | 20 | 0.76 | 25 |
| Example 16 | 1 | 4.0 | 1 | 1 | 16 | 23 | 0.9 | 15 |

### Reference Signs List

- 1:: Polyrotaxane
- 2:: Axial Molecule
- 3:: Cyclic Molecule
- 4:: Bulky End Group
- 5:: Side Chain

## Claims

1. A polyrotaxane monomer (A) having a composite molecular structure comprising:
cyclic molecules, and
an axial molecule that threads through the rings of the cyclic molecules and has a bulky group at both ends thereof so as not to dethread the rings, wherein:
the polyrotaxane monomer has a water content of 5000 ppm or less, which is measured according to a Karl Fischer method,
a side chain is introduced into at least a part of the cyclic molecules, and
a polymerizable functional group is introduced into the side chain.

2. The polyrotaxane monomer (A) according to claim 1, wherein the number-average molecular weight of the side chain of the polyrotaxane monomer (A) is 5000 or less.

3. The polyrotaxane monomer (A) according to claim 1 or 2, wherein:
the cyclic molecules have a reactive functional group, and
the side chain is introduced through reaction with the reactive functional group, and the side chain is introduced into 6% or more and 60% or less of all the reactive functional groups of all the cyclic molecules.

4. The polyrotaxane monomer (A) according to any of claims 1 to 3, wherein the polymerizable functional group is at least one group selected from a hydroxy group, and a (meth)acrylate group.

5. A curable composition comprising:
the polyrotaxane monomer (A) of any of claims 1 to 4, and
any other polymerizable monomer (B) than the polyrotaxane monomer (A).

6. The curable composition according to claim 5, wherein the water content in the polymerizable monomer (B) is 3000 ppm or less.

7. The curable composition according to claim 5 or 6, wherein:
the polymerizable functional group of the polyrotaxane monomer (A) contains a hydroxy group, and
the polymerizable monomer (B) contains an iso(thio)cyanate group-having iso(thio)cyanate compound (B1).

8. The curable composition according to claim 7, wherein:
the polymerizable monomer (B) further contains at least one monomer selected from:
an epoxy group-containing monomer (B2) having an epoxy group,
a (thi)ol compound (B3) having at least one selected from a hydroxy group, and a thiol group, and
an amino group-containing monomer (B4) having an amino group.

9. The curable composition according to claim 5 or 6, wherein:
the polymerizable functional group of the polyrotaxane monomer (A) contains a (meth)acrylate group, and
the polymerizable monomer (B) is a (meth)acrylate group-having (meth)acrylate compound.

10. The curable composition according to any of claim 5 to 8, further
containing hollow particles.

11. A photochromic curable composition comprising:
the curable composition of any of claims 5 to 9, and
a photochromic compound (D).

12. A polishing pad produced by curing the curable composition of any of claims 5 to 8 or 10.

13. A photochromic cured product produced by curing the photochromic curable composition of claim 11.

## Patentansprüche

1. Polyrotaxanmonomer (A) mit einer zusammengesetzten Molekularstruktur, umfassend:
zyklische Moleküle, und
ein axiales Molekül, das durch die Ringe der zyklischen Moleküle fädelt und an seinen beiden Enden eine sperrige Gruppe aufweist, um die Ringe nicht entfädeln zu lassen, wobei:
das Polyrotaxanmonomer einen Wassergehalt von 5000 ppm oder weniger aufweist, der nach einem Karl-Fischer-Verfahren gemessen wird,
in mindestens einen Teil der zyklischen Moleküle eine Seitenkette eingeführt ist, und
eine polymerisierbare funktionelle Gruppe in die Seitenkette eingeführt ist.

2. Polyrotaxanmonomer (A) nach Anspruch 1, wobei das zahlenmittlere Molekulargewicht der Seitenkette des Polyrotaxanmonomers (A) 5000 oder weniger beträgt.

3. Polyrotaxan-Monomer (A) nach Anspruch 1 oder 2, wobei:
die zyklischen Moleküle eine reaktive funktionelle Gruppe aufweisen und
die Seitenkette durch Reaktion mit der reaktiven funktionellen Gruppe eingeführt wird, und die Seitenkette in 6 % oder mehr und 60 % oder weniger aller reaktiven funktionellen Gruppen aller cyclischen Moleküle eingeführt wird.

4. Polyrotaxanmonomer (A) nach einem der Ansprüche 1 bis 3, wobei die polymerisierbare funktionelle Gruppe mindestens eine Gruppe ist, die aus einer Hydroxygruppe und einer (Meth)acrylatgruppe ausgewählt ist.

5. Härtbare Zusammensetzung, umfassend:
das Polyrotaxan-Monomer (A) nach einem der Ansprüche 1 bis 4, und
ein beliebiges anderes polymerisierbares Monomer (B) als das Polyrotaxan-Monomer (A).

6. Härtbare Zusammensetzung nach Anspruch 5, wobei der Wassergehalt in dem polymerisierbaren Monomer (B) 3000 ppm oder weniger beträgt.

7. Härtbare Zusammensetzung nach Anspruch 5 oder 6, wobei:
die polymerisierbare funktionelle Gruppe des Polyrotaxanmonomers (A) eine Hydroxygruppe enthält, und
das polymerisierbare Monomer (B) eine Iso(thio)cyanatgruppen-haltige Iso(thio)cyanatverbindung (B1) enthält.

8. Härtbare Zusammensetzung nach Anspruch 7, wobei:
das polymerisierbare Monomer (B) außerdem mindestens ein Monomer enthält, das ausgewählt ist aus:
einem Epoxidgruppen-haltigen Monomer (B2) mit einer Epoxidgruppe,
einer (Thi)olverbindung (B3) mit mindestens einer Gruppe, ausgewählt aus einer Hydroxygruppe und einer Thiolgruppe, und
einem Aminogruppen-haltigen Monomer (B4) mit einer Aminogruppe.

9. Härtbare Zusammensetzung nach Anspruch 5 oder 6, wobei:
die polymerisierbare funktionelle Gruppe des Polyrotaxanmonomers (A) eine (Meth)acrylatgruppe enthält, und
das polymerisierbare Monomer (B) eine (Meth)acrylatgruppen-haltige (Meth)acrylatverbindung ist.

10. Härtbare Zusammensetzung nach einem der Ansprüche 5 bis 8, die außerdem hohle Teilchen enthält.

11. Photochrome härtbare Zusammensetzung, umfassend:
die härtbare Zusammensetzung nach einem der Ansprüche 5 bis 9, und
eine photochrome Verbindung (D).

12. Polierkissen, hergestellt durch Härten der härtbaren Zusammensetzung nach einem der Ansprüche 5 bis 8 oder 10.

13. Photochromes gehärtetes Produkt, hergestellt durch Härten der photochromen härtbaren Zusammensetzung nach Anspruch 11.

## Revendications

1. Monomère polyrotaxane (A) ayant une structure moléculaire composite comprenant :
des molécules cycliques, et
une molécule axiale qui s'enfile à travers les anneaux des molécules cycliques et possède un groupe volumineux à ses deux extrémités afin de ne pas défaire les anneaux, dans laquelle :
le monomère polyrotaxane a une teneur en eau de 5000 ppm ou moins, qui est mesurée selon la méthode de Karl Fischer,
une chaîne latérale est introduite dans au moins une partie des molécules cycliques, et
un groupe fonctionnel polymérisable est introduit dans la chaîne latérale.

2. Monomère polyrotaxane (A) selon la revendication 1, dans lequel le poids moléculaire moyen en nombre de la chaîne latérale du monomère polyrotaxane (A) est de 5000 ou moins.

3. Monomère polyrotaxane (A) selon la revendication 1 ou 2, dans lequel :
les molécules cycliques ont un groupe fonctionnel réactif, et
la chaîne latérale est introduite par réaction avec le groupe fonctionnel réactif, et la chaîne latérale est introduite dans 6 % ou plus et 60 % ou moins de tous les groupes fonctionnels réactifs de toutes les molécules cycliques.

4. Monomère polyrotaxane (A) selon l'une quelconque des revendications 1 à 3, dans lequel le groupe fonctionnel polymérisable est au moins un groupe choisi parmi un groupe hydroxy et un groupe (méth)acrylate.

5. Composition durcissable comprenant :
le monomère polyrotaxane (A) de l'une quelconque des revendications 1 à 4, et
tout autre monomère polymérisable (B) que le monomère polyrotaxane (A).

6. Composition durcissable selon la revendication 5, dans laquelle la teneur en eau dans le monomère polymérisable (B) est de 3000 ppm ou moins.

7. Composition durcissable selon la revendication 5 ou 6, dans laquelle :
le groupe fonctionnel polymérisable du monomère polyrotaxane (A) contient un groupe hydroxy, et
le monomère polymérisable (B) contient un composé iso(thio)cyanate (B1) comportant un groupe iso(thio)cyanate.

8. Composition durcissable selon la revendication 7, dans laquelle :
le monomère polymérisable (B) contient en outre au moins un monomère choisi parmi :
un monomère contenant un groupe époxy (B2) ayant un groupe époxy,
un composé (thi)ol (B3) ayant au moins un élément choisi parmi un groupe hydroxy et un groupe thiol, et
un monomère contenant un groupe amino (B4) ayant un groupe amino.

9. Composition durcissable selon la revendication 5 ou 6, dans laquelle :
le groupe fonctionnel polymérisable du monomère polyrotaxane (A) contient un groupe (méth)acrylate, et
le monomère polymérisable (B) est un composé de (méth)acrylate possédant un groupe (méth)acrylate.

10. Composition durcissable selon l'une quelconque des revendications 5 à 8, contenant en outre des particules creuses.

11. Composition photochromique durcissable comprenant :
la composition durcissable de l'une quelconque des revendications 5 à 9, et
un composé photochromique (D).

12. Tampon de polissage produit par durcissement de la composition durcissable de l'une quelconque des revendications 5 à 8 ou 10.

13. Produit photochromique durci produit par durcissement de la composition photochromique durcissable de la revendication 11.
